# NEUE EUROPÄISCHE PATENTSCHRIFT

(11) **EP 0 261 307 B2**
(45) Veröffentlichungstag und Bekanntmachung des Hinweises auf die Entscheidung über den Einspruch: **02.12.1998**
(45) Hinweis auf die Patenterteilung: 03.02.1993
(21) Anmeldenummer: 87106856.5
(22) Anmeldetag: 12.05.1987
(51) Int. Cl.: H05K 7/14

(54) **Explosionsgeschütztes Modulgehäuse**
Modular casing protected against explosion
Boîtier modulaire protégé des explosions

(30) Priorität: 26.09.1986 DE 3632676
(43) Veröffentlichungstag der Anmeldung: 30.03.1988
(73) Patentinhaber: R. Stahl Schaltgeräte GmbH, D-74653 Künzelsau (DE)
(72) Erfinder: Miksche, Detlev, D-7119 Niedernhall (DE)
(74) Vertreter: Rüger, Rudolf, Dr.-Ing.

(56) Entgegenhaltungen:
- EP-A- 0 096 652
- EP-A- 0 112 258
- US-A- 3 904 812
- US-A- 4 213 018

## Beschreibung

Die Erfindung betrifft ein explosionsgeschütztes Modulgehäuse für elektrische und/oder elektronische Baugruppen mit den Merkmalen des Oberbegriffs des Anspruchs 1.

Aus dem Siemens-Katalog MP 29, Teil 10, Juni 1984, Seite 10/14, sind explosionsgeschützte Gehäuse für elektronische Baugruppen bekannt, die eine sandgefüllte Kammer enthalten, in der die Leiterplatte mit den elektronischen Bauelementen untergebracht ist. Um die elektrischen Verbindungen mit der sandgekapselten Leiterplatte herzustellen, enthält das Gehäuse außerdem einen Anschlußraum, der in der Schutzart "Erhöhte Sicherheit" ausgeführt ist und beispielsweise Schraubklemmen für die Anschlußverdrahtung enthält. Von diesen Schraubklemmen führen fest angeschlossene Leitungen in die sandgefüllte Kammer, wo sie an der Leiterplatte angeschlossen sind. Die Leitungsdurchführung zu der sandgefüllten Kammer braucht lediglich nach IP 54 ausgeführt zu sein.

Dieser Aufbau ist an sich recht einfach und hat insbesondere den Vorteil, daß das Gehäuse wegen der Sandkapselung nur geringe Wandstärken aufweisen muß, die wesentlich geringer sind als bei Gehäusen, die bei gleichem Volumen in der Schutzart "Druckfeste Kapselung" ausgeführt sind. Außerdem verbessert die Sandfüllung die Wärmeableitung aus dem Inneren des Gehäuses, verglichen mit der Luftfüllung bei einem druckfest gekapselten Gehäuse. Die elektronischen Bauelemente können deswegen bei diesem Gehäuse mit höherer Verlustleistung betrieben werden.

Allerdings hat die Praxis gezeigt, daß hin und wieder elektronische Baugruppen ausfallen und deswegen ausgetauscht werden müssen. Auch im Falle einer Fehler- oder Störungssuche muß unter Umständen die jeweils betrachtete Baugruppe aus der übrigen Schaltung abgetrennt werden. Bei dem bekannten Modulgehäuse muß zu diesem Zweck die Anlage oder zumindest derjenige Teil der Anlage, der das jeweilige Modulgehäuse enthält, spannungslos geschaltet werden, ehe der Anschlußraum"Erhöhte Sicherheit" geöffnet werden darf, um die Zuleitungen darin abzuklemmen.

Bei Anlagen, die die bekannten Modulgehäuse enthalten, ist deswegen während der Fehlersuche oder Fehlerbeseitigung über eine verhältnismäßig große Zeitspanne die Anlage oder der entsprechende Teil stillgelegt, da auch für die anderen, einwandfrei abreitenden Modulgehäuse die Stromversorgung abgeschaltet ist. Dabei müssen nicht nur solche Teile der Anlage stillgelegt sein, die an derselben Stromversorgung hängen wie das auszutauschende Modul, sondern auch diejenigen Teile, von denen oder zu denen Signalleitungen führen, die nicht mehr als eigensichere, im Sinne von DIN EN 50020 gelten, obwohl unter Umständen die Anlage auch bei entfernter fehlerhafter elektronischer Baugruppe zumindest eingeschränkt weiter betrieben werden könnte.

Die EP-A-0 096 652 beschreibt eine schlagwettergeschützte Schaltanlage mit einem Sammelschienenkanal. Der Sammelschienenkanal selbst ist in der Zündschutzart "Erhöhte Sicherheit" ausgeführt und trägt an einer dem Modulgehäuse zugekehrten Frontseite ausschließlich Steckkontakte in der Zündschutzart "Druckfeste Kapselung".

Ausgehend hiervon ist es Aufgabe der Erfindung, ein explosionsgeschütztes Modulgehäuse zu schaffen, das einfacher und schneller aus einer Anlage zu entnehmen und einzusetzen ist, ohne daß aus Gründen des Explosionsschutzes Versorgungsspannungen für die in dem Modulgehäuse untergebrachte Baugruppe oder nicht eigensichere Signalleitungen abgeschaltet werden müssen.

Diese Aufgabe wird erfindungsgemäß durch das Modulgehäuse mit den Merkmalen des Anspruches 1 gelöst.

Dadurch, daß die elektrischen Verbindungen,zumindest soweit sie nicht eigensicher sind, über eine Steckverbindungseinrichtung geführt sind,
die explosionsgeschützt ausgeführt ist,
kann jederzeit die Steckverbindungseinrichtung getrennt werden, ohne daß ansonsten besondere elektrische Maßnahmen erforderlich sind. Schließlich geht auch das Verbinden und Trennen einer solchen Steckverbindungseinrichtung wesentlich schneller als das Öffnen und Wiederherstellen geschraubter elektrischer Verbindungen. Selbst dann, wenn aus irgendwelchen anderen Gründen zum Herausnehmen des Modulgehäuses mit der auszutauschenden Baugruppe die Anlage stillgesetzt werden muß, ist die Abschaltzeit wesentlich kürzer als bei geschraubten Verbindungen.

Auf diese Weise wird es möglich, auch in exgefährdeten Räumen eine Baugruppenstecktechnik zu verwirklichen, wie sie in nicht geschützten Bereichen bereits üblich ist und sich bewährt hat. Diese Stecktechnik läßt sich mit den bekannten Modulgehäusen, die den Anschlußraum "Erhöhte Sicherheit" aufweisen, nicht verwirklichen, selbst dann nicht, wenn die Mehrzahl der Verbindungen eigensicher ist und über eine normale Buchsen- oder Messerleiste nach DIN 41612 oder 41617 od.dgl. geführt werden könnten. Bei dem neuen Modulgehäuse dagegen können derartige Stecker- oder Buchsenleisten sinnvollerweise zusammen mit der explosionsgeschützten Steckverbindungseinrichtung verwendet werden, wobei die eigensicheren Verbindungen zu bzw. von dem Modulgehäuse über die handelsüblichen Kontaktleisten geführt sind.

Zur Halterung des Modulgehäuses sind zweckmäßigerweise parallel und mit Abstand voneinander verlaufende Führungsglieder vorgesehen.

Besonders raumsparend werden die Verhältnisse, wenn wenigstens ein Teil der Steckverbindungseinrichtung Steckerstifte enthält, die bei zusammengesteckter Steckverbindungseinrichtung einzeln und für sich druckfest gekapselt sind, da hierdurch sehr kleine zu schützende Volumina entstehen, die erheblich geringere Wandstärken erfordern als größere Volumina, die erforderlich sind, wenn mehrere Steckerstifte gemeinsam druckfest gekapselt sind.Diese druckfeste Kapselung läßt sich einfach dadurch erreichen, daß der andere Teil der Steckverbindungseinrichtung eine Bohrung an der entsprechenden Stelle enthält, die bei eingestecktem Steckerstift mit diesem zusammen einen zünddurchschlagsicheren Spalt bildet, während die elektrische Kontaktstelle für den Steckerstift, bezogen auf die Steckrichtung des Steckers, hinter der Bohrung liegt. Die Wandung der Bohrung besteht dabei aus elektrischem, nicht leitendem Material. Diese Kontaktstelle kann von einer Buchse gebildet sein, in die der Steckerstift schließlich eindringt.

Da die Steckerstifte zur Ausbildung des zünddurchschlagsicheren Spaltes eine verhältnismäßig große Länge aufweisen und andererseits auch die Buchsen in radialer Richtung Platz beanspruchen, ist es zweckmäßig wenn der Steckerstift im Bereich des entstehenden zünddurchschlagsicheren Spaltes einen vergrößerten Durchmesser aufweist, verglichen mit dem an seinem Vorderende liegenden Abschnitt, der im eingesteckten Zustand in die Buchse eindringt. Auf diese Weise kann der Außendurchmesser der Buchse nahezu gleich dem Außendurchmesser des Steckerstiftes an der dicksten Stelle werden, während andererseits eine genügende Festigkeit erhalten wird.

Um bei getrennter Steckverbindungseinrichtung die Schutzvorschrift nach IP 54 zu erfüllen, ist es entweder möglich, Schaltermittel zuverwenden, um die spannungsführenden Buchsen oder Steckerstifte spannungslos zu schalten oder die Buchsen durch selbsttätig schließende Abdeckmittel abzudecken.

Die Abdeckmittel können von einem oder mehreren Schiebern gebildet sein, die quer zu der Längsachse der Bohrungen für die Buchsen längsverschieblich gehaltert sind und Öffnungen entsprechend dem Muster der Bohrungen enthalten, so daß in einer Schieberstellung die Bohrungen verschlossen und in der anderen Schieberstellung die Bohrungen freigegeben sind, wobei die Betätigung des oder der Schieber beim Zusammenstekken der beiden Teile der Steckverbindungseinrichtung erfolgt.

Es ist auch möglich, die Bohrungen durch einen Zapfen zu verschließen, der in der Bohrung sowie der Buchse längsverschieblich gehaltert ist und beim Einschieben des Steckerstiftes in die Buchse zurückgedrückt wird, während beim Ziehen des Steckerstiftes der Zapfen von einer Druckfeder in die Bohrung vorgeschoben wird. Falls der die Bohrung verschließende Zapfen nicht aus Isoliermaterial, sondern aus elektrisch leitendem Material bestehen soll, ist es möglich, die Buchse gegenüber der den zünddurchschlagsicheren Spalt begrenzenden Bohrung zurückzuversetzen und den verschiebbaren Zapfen zwischen der Bohrung und der Buchse hin- und herschiebbar zu haltern, so daß der Zapfen in einer Stellung mit der Buchse elektrischen Kontakt macht, während in der anderen Endstellung die elektrische Verbindung unterbrochen ist, während die Betätigung des Zapfens durch den Steckerstift erfolgt.

Eine sehr einfache Verschlußmöglichkeit besteht schließlich darin, vor den Bohrungen eine Membrane aus elastischem Material anzubringen, die im Bereich der Bohrungen geschlitzt oder eingeschnitten ist, derart, daß die Steckerstifte beim Zusammenstecken der Teile der Steckverbindungseinrichtung durch die Membrane hindurch in die Bohrungen bzw. Buchsen eindringen können, während bei gezogenen Steckerstiften die Membrane in ihre Ausgangsstellung zurückkehrt, um die Bohrungen nach IP 54 zu verschließen.

Das neue Modulgehäuse wird bevorzugt in einem Baugruppenträger verwendet, der in einem Rahmen eines oder mehrere Paare von Führungsgliedern für die Modulgehäuse enthält, die beim Einschieben des Modulgehäuses dessen Führungsglieder aufnehmen, wobei an der Stelle, an der bei eingestecktem Modulgehäuse der dem Modulgehäuse zugeordnete Teil der Steckverbindungseinrichtung zu liegen kommt, der dazu komplementäre Teil der Steckverbindungseinrichtung angeordnet ist. Zusätzlich können hierzu noch ungeschützte Steckverbindungseinrichtungen gehaltert sein, über die die eigensicheren Verbindungen geführt sind.

Um eine weitgehende Berührungsfreiheit zu bekommen, ist es vorteilhaft, wenn die in dem Baugruppenträger angeordneten Teile der Steckverbindungseinrichtungen ohne Steckerstifte ausgebildet sind.

Der Baugruppenträger bildet zusammen mit den explosionsgeschützten Modulgehäusen ein Modulstecksystem, in das weitgehend beliebig Modulgehäuse eingesteckt oder aus dem diese Modulgehäuse herausgezogen werden können, ohne daß aus Gründen des Explosionsschutzes Spannungen abgeschaltet werden müssen.

Der in dem Baugruppenträger untergebrachte Teil der Steckverbindungseinrichtung enthält entweder einen Anschlußraum erhöhter Sicherheit für den Anschluß der Leitungen oder die Leitungen sind in bekannter Weise in diesem Teil der Steckverbindungseinrichtung explosionsgeschützt vergossen.

Außer der druckfesten Kapselung der Kontakt mittel der Steckverbindungseinrichtung ist es auch möglich, die Kontaktmittel in der Zündschutzart "Erhöhte Sicherheit" nach DIN EN 50019 "e" auszuführen, um ein leicht austauschbares Modulgehäuse zu erhalten. In diesem Falle ist zwangsläufig zumindest in demjenigen Teil der Steckverbindungseinrichtung ein Schalter in der Zündschutzart "Druckfeste Kapselung" vorgesehen, dessen Kontaktmittel sonst nach dem Trennen der beiden Teile voneinander unter Spannung stehen würden. Durch den Schalter werden die Kontaktmittel spannungslos geschaltet. Dabei ist die Räumliche Anordnung derart getroffen, daß die Schalter erst schließen, wenn beim Zusammenstecken der Teile zwischen den Kontaktmitteln bereits die elektrische Verbindung hergestellt ist.

Andererseits müssen die Schalter beim Auseinanderziehen der Teile bereits die elektrischen Verbindungen stromlos geschaltet haben, noch ehe die Kontaktmittel außer Eingriff geraten.

Bei dieser Ausführungsform enthält die durch einander zugeordnete Kontaktmittel der beiden Teile gebildete Kontaktstrecke eine Vielzahl von Kontaktstellen, die jeweils weitgehend unabhängig voneinander federnd bewegbar sind. Damit ist sichergestellt, daß in dem jeweils zulässigen Strombereich nie alle Kontaktstellen gleichzeitig die mechanische Verbindung zu dem anderen Kontaktmittel verlieren, wodurch Funken entstehen könnten.

Die unabhängig voneinander bewegbaren Kontakstellen können dabei wahlweise in dem als Buchse ausgebildeten Kontaktmittel oder auf dem als Stecker ausgebildeten Kontaktmittel vorgesehen sein. Dabei hat allerdings die Anbringung in der Buchse den Vorteil des besseren Schutzes für diese federnden Kontaktstellen, die im Hinblick auf die notwendige Miniaturisierung durchaus filigran sind und deswegen einen Schutz erfordern.

Als bewegliche Kontaktstellen kommen sowohl Lamellen, die an einer entsprechend geschlitzten Hülse ausgebildet sind, in Frage als auch beispielsweise Büschelstecker, wie sie sonst z.B. im Hochfrequenzbereich Anwendung finden.

In der Zeichnung sind Ausführungsbeispiele des Gegenstandes der Erfindung dargestellt. Es zeigen:
- Fig. 1: einen Baugruppenträger gemäß der Erfindung mit einem explosionsgeschützten Modulgehäuse gemäß der Erfindung, teilweise geschnitten und aufgebrochen, in einer perspektivischen Darstellung,
- Fig. 2: das explosionsgeschützte Modulgehäuse nach Fig. 1 in einer Draufsicht mit abgenommener oberer Wand,
- Fig. 3: das explosionsgeschützte Modulgehäuse nach Fig. 1 mit abgenommener Seitenwand und teilweise aufgebrochenen, an dem Gehäuse gehalterten Teil der explosionsgeschützten Steckvorrichtung,
- Fig. 4: die explosionsgeschützte Steckvorrichtung, die in dem Baugruppenträger sowie dem explosionsgeschützten Modulgehäuse nach Fig. 1 zur Anwendung kommt, in einer perspektivischen Darstellung unter Veranschaulichung des inneren Aufbaus,
- Fig. 5: ein weiteres Ausführungsbeispiel der explosionsgeschützten Steckvorrichtung für den Baugruppenträger und das explosionsgeschützte Modulgehäuse nach Fig. 1, wobei die Bohrungen für die Buchsen durch einen Schieber verschließbar sind, in einer schematisierten geschnittenen Seitenansicht,
- Fig. 6: den Schieber der explosionsgeschützten Steckvorrichtung nach Fig. 5, in perspektivischer Darstellung,
- Fig. 7: eine explosionsgeschützte Steckverbindungseinrichtung für das explosionsgeschützte Modulgehäuse und den Baugruppenträger nach Fig. 1, wobei die Bohrung für die Buchse von einem Zapfen aus elektrischem nicht leitendem Material verschließbar ist, geschnitten und in einer schematisierten Seitendarstellung,
- Fig. 8: eine stark schematisierte explosionsgeschützte Steckvorrichtung für das explosionsgeschützte Modulgehäuse und den Baugruppenträger nach Fig. 1, wobei die Bohrung für die Buchse durch einen Zapfen aus elektrisch leitendem Material verschließbar ist, geschnitten und in einer Seitendarstellung,
- Fig. 9: eine explosionsgeschützte Steckverbindungseinrichtung für das explosionsgeschützte Modulgehäuse und den Baugruppenträger nach Fig. 1, wobei die Bohrung für die Buchse von einer entsprechend eingeschnittenen Membrane verschlossen ist, geschnitten und in einer schematisierten Seitenansicht,
- Fig.10: die Membrane für die explosionsgeschützte Steckverbindungseinrichtung nach Fig. 9, in einer perspektivischen Darstellung,
- Fig. 11: eine explosionsgeschützte Steckvorrichtung, die in dem Baugruppenträger sowie in dem explosionsgeschützten Modulgehäuse nach Fig. 1 verwendbar und in der Zündschutzart "Erhöhte Sicherheit" ausgeführt ist, in einer Seitenansicht und teilweise aufgebrochen und
- Fig.12: eine vergrößerte Darstellung einer der Steckbuchsen der Steckverbindungseinrichtung nach Fig. 11 in einer teilweise geschnittenen perspektivischen Darstellung.

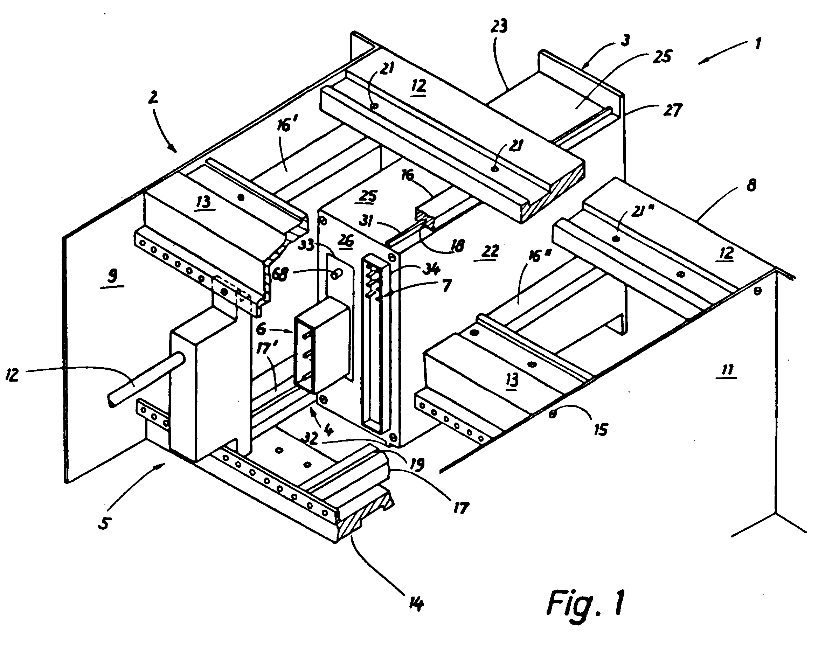

In Fig. 1 ist perspektivisch und schematisiert bzw. vereinfacht ein explosionsgeschütztes Modulstecksystem 1 veranschaulicht, das einen Baugruppenträger 2 sowie in den Baugruppenträger einschiebbare explosionsgeschützte Modulgehäuse 3 aufweist, von denen lediglich eines veranschaulicht ist. Die elektrische Verbindung zwischen dem Baugruppenträger 2 und dem Modulsteckgehäuse 3 erfolgt für die sogenannten "nicht eigensicheren" Stromkreise über eine zweiteilige Steckverbindungseinrichtung 4 mit einem in dem Baugruppenträger 2 gehalterten Teil 5 und einem an dem Modulgehäuse 3 angebrachten Teil 6, die beide im zusammengesteckten Zustand für die darin befindlichen Kontaktmittel eine druckfeste Kapselung nach DIN EN 50018 bilden.

Die Verbindungen der eigensicheren Stromkreise erfolgt über eine handelsübliche, an dem Modulgehäuse 3 angebrachte Steckerleiste, die beispielsweise nach DIN 41612 oder DIN 41617 od.dgl. ausgeführt ist. Im eingesteckten Zustand macht diese Steckerleiste 7 in einer in dem Baugruppenträger 2 angebrachten Buchsenleiste Kontakt, die ebenfalls handelsüblich ist und aus Gründen der Übersichtlichkeit nicht dargestellt ist.

Der Baugruppenträger 2 enthält einen Rahmen 8 mit zwei Seitenwänden 9 und 11, die über insgesamt vier parallel und mit Abstand voneinander verlaufende und auf den Seitenwänden 9 und 11 senkrecht stehenden Tragschienen oder Streben 12, 13, und 14 miteinander verbunden sind; die vordere untere Tragschiene ist aus Darstellungsgründne nicht erkennbar. Die Tragschienen 12 bis 14 sind mittels Schrauben 15 mit den beiden Seitenwänden 9 und 11 verschraubt, und zwar liegen die beiden Tragschienen 12 und 13 an der Oberseite bzw. Oberkante der Seitenwände 9 und 11, während die anderen beiden Tragschienen, von denen nur die Tragschiene 14 sichtbar ist, an der Unterseite angeordnet sind.

Die Tragschienen 12, 13, 14 dienen der Halterung von Führungsschienen 16 und 17, die, wie das Paar 16 und 17 zeigen, in Richtung aufeinander zu offene und aufeinander ausgerichtete Führungsnuten 18 und 19 enthalten. Die Führungsschienen 16 und 17 sind an den Tragschienen 12, 13, 14 mit Schrauben 21 angeschraubt, und zwar so, daß sie parallel und mit Abstand zueinander und parallel zu den Seitenwänden 9, 11 verlaufen.

Je nach Bedarf sind in dem Rahmen 8 des Baugruppenträgers 2 weitere Führungsschienen 16' oder 16" mit Schrauben 21' und 21" befestigt. Mit diesen Führungsschienen 16', 16" fluchten entsprechende, an der Unterseite angebrachte Führungsschienen, von denen lediglich die Führungsschiene 17' erkennbar ist.

Der Abstand der Führungsschienen 16, 17 voneinander entspricht, wie gezeigt, der Höhe des explosionsgeschützten Modulgehäuses 3, so daß es zwischen den Führungsschienen 16, 17 einführbar und von diesen quer zur Einsteckbewegung gehalten ist.

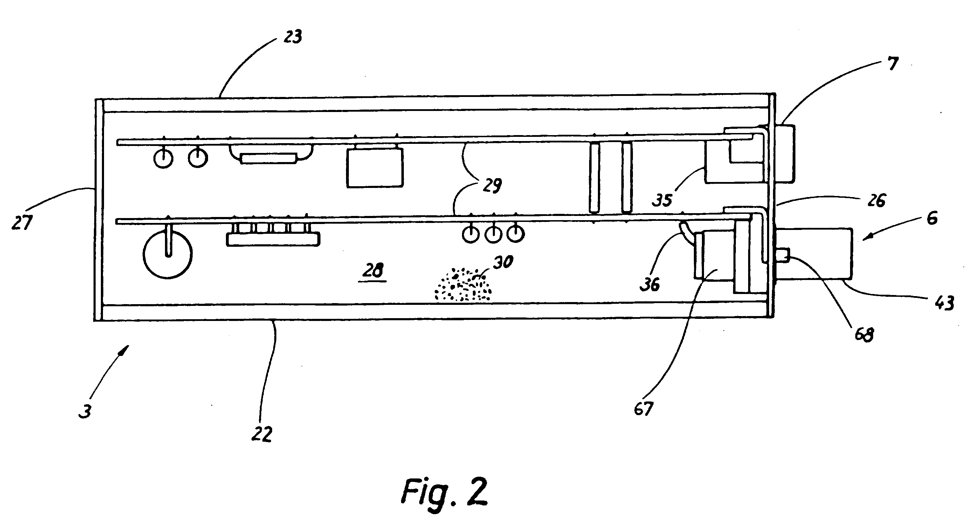

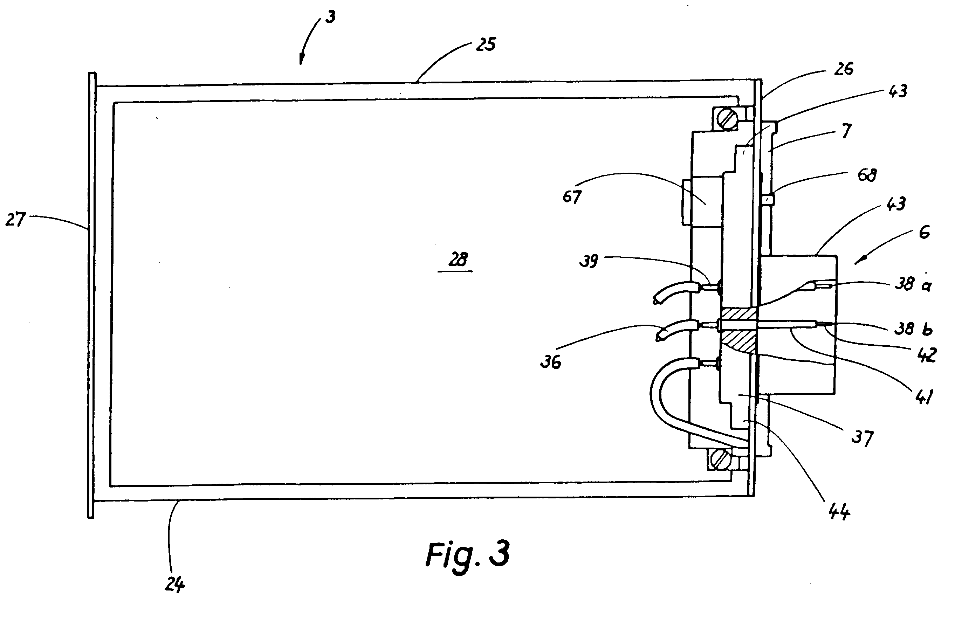

In den Fig. 2 und 3 ist das explosionsgeschützte Modulgehäuse 3 geöffnet veranschaulicht. Dieses Modulgehäuse mit seinen beiden Seitenwänden 22,23, einer unteren Wand 24, einer oberen Wand 25 sowie einer Rückwand 26 und einer Vorderwand 27 hat etwa quaderförmige Gestalt und begrenzt eine Kammer 28, in der elektronische Baugruppen 29, die auf Leiterkarten aufgebaut sind, angeordnet sind. Die Kammer 28 des explosionsgeschützten Modulgehäuses 3 ist mit Sand oder Glaskugeln 30 gefüllt, so daß sich für die darin untergebrachten Baugruppen 29 eine Sandkapselung ergibt, d.h. die Baugruppen 29 sind in dem Modulgehäuse 3 in der Zündschutzart "Sandkapselung" nach DIN EN 50017 "q" geschützt. Die Wände 22 bis 27 können in beliebiger Weise miteinander verbunden sein, soweit die jeweils gewählte Verbindungstechnik die entsprechenden Schutzvorschriften erfüllt und die Baugruppen 29 in der Kammer 28 nach der Schutzvorschrift IP 54 mechanisch gegen Staub und Spritzwasser gescnützt sind. Bei Einhaltung dieser Schutzvorschrift wird außerdem sichergestellt, daß die Sandfüllung 30 in der Kammer 28 bleibt und seine Schutzfunktion erfüllt.

An der oberen und der unteren Wand 24, 25 sind zwei in Längsrichtung des Modulgehäuses 3 verlaufende Führungsleisten 31, 32 angeformt, die in ihren Abmessungen auf die Führungsnuten 18, 19 in den Führungsschienen 16, 17 abgestimmt sind und in diesen Nuten beim Einstecken des Modulgehäuses in den Baugruppenträger 2 entlanggleiten. Sie sorgen hierbei gleichzeitig dafür, daß beim Einstecken des Modulgehäuses 3 angebrachten Teile 6 und 7 der Steckverbindungseinrichtungen 4 die in dem Baugruppenträger 2 gehalterten Teile 5 in der ricntigen Weise treffen.

Die Rückwand 26 des gezeigten Modulgehäuses 3 enthält zwei rechteckige nebeneinanderliegende Öffnungen 33 und 34, in die der Teil 6 der druckfest gekapselten Steckverbindungseinrichtung 4 und die Steckerleiste 7 eingesetzt sind, wobei auch die Steckerleiste 7 so ausgeführt und eingesetzt ist, daß das Modulgehäuse 3 die Schutzvorschrift IP 54 erfüllt; entsprechendes gilt für den Teil 6. Im Inneren des Modulgehäuses 3 sind die Kontaktmittel der Steckerleiste 7 sowie der explosionsgeschützten Steckverbindungseinrichtung 6 mit den elektronischen Baugruppen 29 verbunden, und zwar entweder indem Verlängerungen 35 der Kontaktmittel unmittelbar in die Leiterplatten der Baugruppen 29 eingelötet sind oder mittels einer freien Verdrahtung 36, die von den Kontaktmitteln zu den entsprechenden Anschlußpunkten auf den Leiterplatten führen.

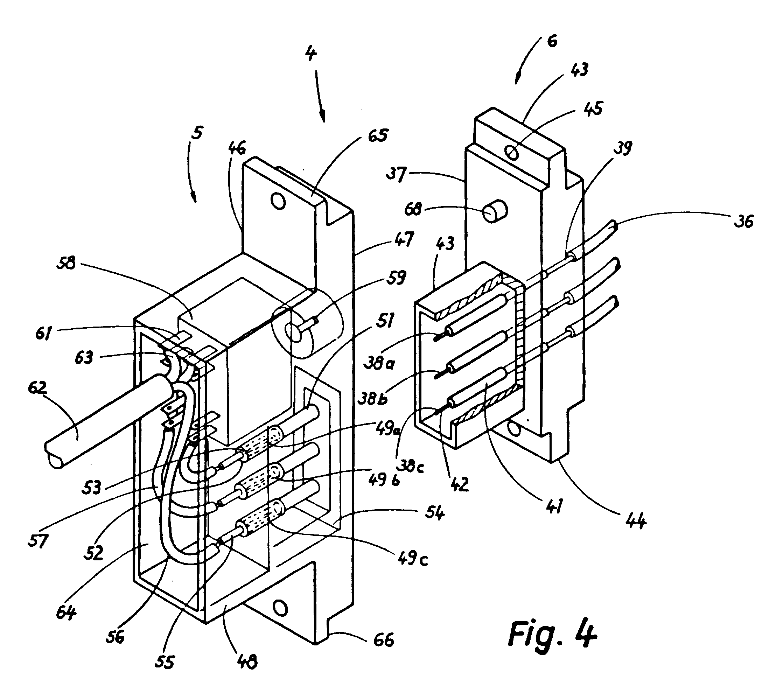

In Fig. 4 sind sowohl der in dem Modulgehäuse 3 sitzende Teil 6 als auch der in dem Baugruppenträger an den Tragschienen 13 und 14 angeschraubte Teil 5 der explosionsgeschützten Steckverbindungseinrichtung vergrößert perspektivisch dargestellt und es ist in dieser Figur der innere Aufbau erkennbar.

Hiernach enthält der Teil 6 einen etwa plattenförmigen, aus Isolierstoff bestehenden Grundkörper 37, der beispielsweise in einem Spritzgießvorgang hergestellt ist. In dem Grundkörper 37 sind in dem gezeigten Ausführungsbeispiel insgesamt drei im wesentlichen zylindrische Steckerstifte 38a, 38b, 38c druckdicht verankert, beispielsweise indem sie in den Grundkörper 37 bei deren Herstellung mit eingespritzt sind. Die Steckerstifte bestehen zumindest auf ihrer Oberfläche aus einem elektrisch gut leitenden Material und ragen nach rückwärts durch den Grundkörper 37 hindurch, wo sie Anschlußfahnen 39 für die Verdrahtung 36 bilden. Um die Steckerstifte 38a ... 38c, die rechtwinklig zu dem Grundkörper 37 und damit rechtwinklig zu der Rückwand 26 des Modulgehäuses 3 verlaufen,unverrückbar zu haltern, weisen sie in bekannter Weise in dem in dem Grunkörper 37 eingebetteten Abschnitt Verjüngungen und/oder Verstärkungen auf, die einen formschlüssigen Verbund mit dem Grundkörper 37 ergeben. Der nach außen, bezogen auf das Modulgehäuse 3 hervorstehende Teil der Steckerstifte 38a...38c weist zwei zylindrische Abschnitt 41 und 42 auf, die zueinander koaxial sind, jedoch unterschiedlichen Durchmesser aufweisen, und zwar ist der längere Abschnitt 41 mit dem größeren Durchmesser dem Grundkörper 37 unmittelbar benachbart, während der Abschnitt 42 mit dem kleineren Durchmesser an der freien Spitze der Steckerstifte 38a...38c liegt.

Die Gruppe von insgesamt drei Steckerstiften 38a...38c ist von einem Schutzkragen 43 rohrförmig umgeben, der nach Art eines kurzen Rechteckrohres 43 ausgebildet ist und einstückiger Bestandteil des Grundkörpers 37 ist. Der Schutzkragen 43 hat eine Tiefe bzw. Länge, die der Länge der Steckerstifte 38a...38c entspricht, d.h. die Steckerstifte 38a...38c springen mit ihren Spitzen gegenüber dem vorderen Rand des Schutzkragens 43 geringfügig zurück. Sowohl der Schutzkragen 43 als auch die Steckerstifte 38a...38c verlaufen parallel zu den Führungsleisten 31, 32.

Der Schutzkragen 43 braucht nicht rundum geschlossen zu sein, sondern er kann auch Schlitze enthalten, falls dies fertigungstechnisch günstiger ist.

Die Befestigung des Teils 6 in dem Modulgehäuse 3 erfolgt mit Flanschen 43 und 44, die an den Grundkörper 37 angespritzt sind und im montierten Zustand an der Rück- oder Innenseite der Rückwand 26 anliegen. In den Flanschen sind Bohrungen 45 für Befestigungsschrauben vorgesehen.

Der an den Halteschienen 13 und 14 des Modulträgers 2 angebrachte Teil 5 der Steckverbindungseinrichtung 4 weist einen gehäuseartigen isolierenden Grundkörper 46 auf mit einer Grundplatte 47, an deren Rückseite ein Fortsatz 48 nach Art eines Vierkantrohrstückes einstückig angeformt ist. Die Grundplatte 47 enthält zylindrische Kammern oder Öffnungen 49a...49c, die in ihrer Anzahl und Anordnung der Anzahl und dem Anordnungsmuster der Steckerstifte 38a...38c entsprechen bzw. zu diesen spiegelsymmetrisch sind und bis in den Fortsatz 48 reichen, wo sie an ihrer Rückseite druckdicht verschlossen sind. Die zylindrischen Kammern 49a...49c sind untereinander gleich und bestehen aus einem ersten, an der Vorderseite des Teiles 5 mündenden zylindrischen Abschnitt 51 sowie einem zweiten dahinterliegenden zylindrischen Abschnitt 52, in dem jeweils eine elektrische Steckbuchse 53 in radialer Richtung schwimmend, in Längsrichtung jedoch unverschieblich untergebracht ist. Der Durchmesser des zylindrischen Abschnittes 51 entspricht dem Durchmesser des zugehörigen Steckerstiftes 38a...38c im Bereich 41 mit dem größeren Durchmesser, und zwar so, daß wenn der Steckerstift 38a...38c in die entsprechende Kammer 49a...49c eingesteckt ist, sich zwischen der zylindrischen Bohrung 51 und dem Abschnitt 41 ein zünddurchschlagsicherer Spalt nach DIN EN 50018 ergibt. Der zylindrische Abschnitt 52, in dem sich Buchse 53 befindet, ist so bei eingestecktem Steckerstift 38a...38c ein für sich druckfest gekapselter Raum.

Damit das Zusammenstecken der beiden Teile 5 und 6 nicht durch den Schutzkragen 43 behindert ist, enthält der Grundkörper 46 für die Aufnahme des Schutzkragens 43 eine entsprechend komplementäre Ausnehmung 54. Sowohl die Ausnehmung 54 als auch der Schutzkragen 43 haben keine Schutzfunktion im Sinne eines Explosionsschutzes.

Jede in einer eigenen zylindrischen Kammer 49a...49c untergebrachte Buchse 53 trägt an ihrer Rückseite eine Kontaktfahne 55, die in den rohrförmigen Fortsatz 48 hineinragt, wo eine elektrische Anschlußleitung oder eine Verbindungsleitung 57 unlösbar angeschlossen ist.

Oberhalb der zylindrischen Kammern 49a...49c sitzt in dem Grundkörper 46 ein ein- oder mehrpoliger Mikroschalter 58, der in der Zündschutzart "Druckfeste Kapselung" ausgeführt ist und dessen Betätigungsstift 59 in Richtung auf den einzuführenden Teil 6 aus der Vorderseite der Grundplatte 57 vorragt und dessen Anschlußfahnen 61 sich in dem rohrförmigen Fortsatz 48 befinden. Über den Mikroschalter 58 werden solche elektrischen Verbindungen geführt, die, wenn der Teil 6 aus dem Teil 5 herausgezogen ist, die entsprechenden zugeordneten Buchsen 53 unter Spannung halten, d.h. im veranschaulichten Falle Zuleitungen für die Buchsen 53 in den zylindrischen Kammern 49a und 49b.

Die explosionsgeschützte elektrische Verbindung mit dem Teil 5 geschieht über ein mehrpoliges Kabel 62, dessen einzelne Adern, wie die Ader 56, entweder unmittelbar an eine Anschlußfahne 55 einer Buchse 53 angelötet oder angeschweißt sind oder dessen Einzeladern, wie eine Einzelader 63, an entsprechende Anschlußfahnen 61 des Mikroschalters 58 angeschlossen sind, der über andere Anschlußfahnen 61 und Verbindungsleitungen 57 mit entsprechenden Buchsen 53 elektrisch verbunden ist. Der Innenraum des Fortsatzes 48 ist in bekannter Weise nach dem Herstellen der dauerhaften elektrischen Verbindungen mit einer Kunstharzmasse 64 vergossen.

Mit Hilfe von seitlichen Flanschen 65 und 66 ist der Teil 5 an den Tragschienen 13 und 14 gehaltert, und zwar an derjenigen Stelle, an der sich bei eingestecktem Modulgehäuse 3 der Teil 6 befindet, so daß die elektrische Verbindung über die explosionsgeschützte Steckverbindungseinrichtung 4 hergestellt ist.

Falls die in dem Modulgehäuse 3 untergebrachte Baugruppe 29 ihrerseits Speicher für elektrische Energie enthält, beispielsweise Glättungskondensatoren, die in der Lage sind, Spannungen und Ströme an Steckerstifte 38a bis 38c zu liefern, die außerhalb des als eigensicher angesehenen Stromspannungsbereiches liegen, kann auch in dem Teil 6 ein Mikroschalter 67 gehaltert sein, der in der Zündschutzart "Druckfeste Kapselung" ausgeführt ist und dessen Betätigungsstift 68 aus dem Grundkörper 37, wie gezeigt, hervorsteht. Dieser Mikroschalter 67 sorgt dafür, daß bei gezogenem Teil 6, wenn also die Steckerstifte 38a bis 38c aus dem Teil 5 herausgezogen sind, spannungslos geschaltet sind (siehe Fig. 2 und 3).

Wenn bei dem Modulstecksystem 1 nach Fig. 1 das explosionsgeschützte Modulgehäuse 3 mit seiner Rückwand 26 voraus und dem darauf befestigten Teil 6 bzw. der Steckerleiste 7 voraus, zwischen die entsprechenden Führungsschienen 16 und 17 in den Rahmen 8 eingesteckt wird, dringen die Steckerstifte 38a...38c in die zylindrischen Bohrungen 51 der zugehörigen, die Buchsen 53 enthaltenden zylindrischen Kammern ein, in dem Maße, in dem das explosionsgeschützte Modulgehäuse 3 vorgeschoben wird. Noch ehe ein elektrischer Kontakt zwischen den verjüngten Abschnitten 42 der Steckerstifte 38a...38c mit den Steckbuchsen 53 zustandekommt, bilden die Abschnitte 41 zusammen mit den Bohrungen 51 einen zünddurchschlagsicheren ex-Spalt mit ausreichender Länge, so daß, wenn bei der anschließenden Kontaktgabe Funken entstehen, der Raum, in dem diese Funken hervorgerufen werden, bereits im Sinne der Schutzvorschrift druckfest gekapselt ist. Diese Kontaktgabe tritt ein, wenn das Modulgehäuse 3 weit genug eingesteckt ist. Im Verlauf des weiteren Einschiebens dringen die Steckerstifte 38a...38c mit ihren verjüngten Abschnitten 42 tiefer in die Buchsen 53 ein. Gleichzeitig hierbei werden auch die Betätigungsstifte 59 und 68 der Mikroschalter 58 und 67 niedergedrückt, womit die von ihnen unterbrochenen elektrischen Verbindungen geschlossen werden. Wenn das explosionsgeschützte Modulgehäuse 3 vollständig eingesteckt ist, sind über die explosionsgeschützte Steckverbindungseinrichtung 4 die nicht eigensicheren Stromkreise zu den elektronischen Baugruppen 29 in dem Modulgehäuse 3 geschlossen. Gleichzeitig sind auch die elektrischen Verbindungen der eigensicheren Stromkreise über die Steckerleiste 7 und die entsprechende Buchsenleiste hergestellt, die, wie der Teil 5, an den rückwärtigen Tragschienen 13 und 14 an der entsprechenden Stelle befestigt sind.

Beim Herausziehen des Modulgehäuses 3 werden umgekehrt durch Herausziehen der Steckerleiste 7 die eigensicheren Stromkreise unterbrochen und auch die nicht eigensicheren Stromkreise, wobei eventuell enstehende Öffnungsfunken in den als druckfest gekapselte Räume anzusehenden zylindrischen Kammern 49a...49c hervorgerufen werden, die zur Rückseite hin durch die Vergußmasse 64 und zu der Vorderseite des Teils 5 hin durch den ex-Spalt verschlossen sind, der zwischen der Bohrung 51 und dem entsprechenden Abschnitt 41 des Steckerstiftes 38a...38c ausgebildet ist. Da beim Herausziehen des Modulgehäuses 3 das Niederdrücken der Betätigungsstifte 68 und 59 aufhört, unterbrechen die Mikroschalter 58 und 67 die elektrischen Verbindungen zu den entsprechenden Buchsen 53 oder Steckerstiften 38a...38c, so daß diese spannungslos geschaltet sind.

Ersichtlicherweise müssen vor dem Einsetzen oder dem Entfernen des Modulgehäuses 3 keine zusätzlichen Schalter willkürlich betätigt werden, da sämtliche notwendigen Strom- und Spannungsunterbrechungen selbsttätig beim Ziehen des Modulgehäuses 3 unterbrochen oder beim Einstecken hergestellt werden, wobei die beteiligten Buchsen und Steckerstifte Schalterfunktion übernehmen und der dabei auftretende Schaltvorgang in jeweils druckfest gekapselten Kammern erfolgt.

Anstatt die elektrischen Verbindungen zwischen den Buchsen 53 und der Zuleitung 62 zu vergießen, kann an der Rückseite des Teils 5 ein Anschlußraum erhöhte Sicherheit vorgesehen sein, in dem die Zuleitung 62 mit Klemmschrauben angeklemmt ist.

Um die notwendigen Schutzvorschriften zu erfüllen, müssen nicht notwendigerweise die metallischen Teile der elektrischen Steckverbindungseinrichtung spannungslos geschaltet werden, sondern es genügt auch, wenn sie durch einfache Maßnahmen abgedeckt werden. In diesem Falle erfolgt zwangsläufig der elektrische Schaltvorgang durch das Trennen von Steckerstift und Buchse.

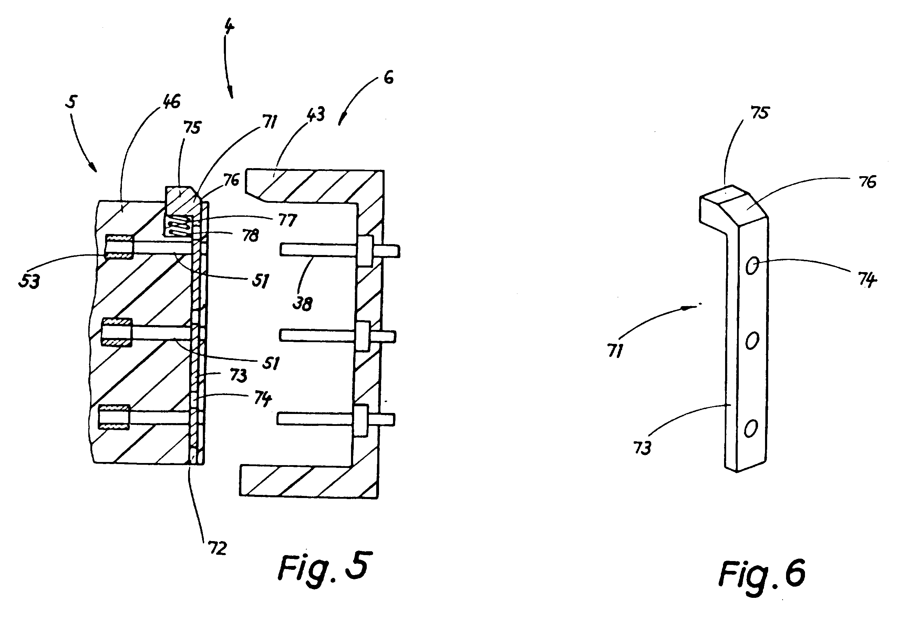

Ausführungsbeispiele, bei denen die Buchsen nach dem Ziehen des Modulgehäuses 3 abgedeckt sind, sind in den Fig. 5 bis 10 dargestellt, wobei für die einander entsprechenden Teile dieselben Bezugszeichen verwendet sind. Außerdem sind die Fig. 5 bis 10 stark vereinfacht und die Teile 5 und 6 der Steckverbindungseinrichtung sind nur ausschnittsweise gezeigt. So sind die Steckerstifte 38 mit durchgehend gleichem Durchmesser veranschaulicht und es sind die übrigen Maßnahmen, wie Vergießen u.dgl.. nicht gezeigt.

Bei dem Ausführungsbeispiel nach Fig. 5 ist in dem Grundkörper 46 ein Schieber 71 längsverschieblich geführt, der bei gezogenem Teil 6 die Bohrungen 51 verschließt. Zu diesem Zweck enthält der Grundkörper 56 knapp hinter der außenliegenden Mündung der Bohrungen 51 einen rechtekkigen Kanal 72, der rechtwinklig zu den Achsen der zueinander parallelen Bohrungen 51 verläuft. In diesem Kanal 72 steckt eine im Querschnitt rechteckige, längliche Zunge 71 mit entsprechend dem Muster der Bohrungen 51 angeordneten Öffnungen 74, so daß in einer Stellung der Zunge 73 in dem Kanal 72 der hinter dem Schieber 71 liegende Teil der Bohrungen 51 von vorne her zugänglich ist.

Am oberen Teil der Zunge 73 ist ein Betätigungsstück 75 einstückig angeformt, das eine abgeschrägte Betätigungsfläche 76 aufweist, die dem Teil 6 der Steckverbindungseinrichtung 4 zugekehrt ist. Das Betätigungsstück 75 ist in einer Ausnehmung 77 in dem Grundkörper 46 verschiebbar, in den auch eine Schraubenfeder 78 untergebracht ist, die an der Unterseite des Betätigungsstücks 75 angreift und den Schieber 71 in eine Stellung vorspannt, in der die Bohrungen 51 nach außen hin verschlossen sind. In dieser Stellung liegen die Öffnungen 74, wie gezeigt, jeweils ein kurzes Stück oberhalb der Bohrungen 51. Beim Einstecken des Teils 6 in das Teil 5 kommt der Schutzkragen 43 mit der abgeschrägten Fläche 46 in Eingriff, so daß bei einem weiteren Vorschieben das Betätigungsstück 75 in die Ausnehmung 77 eingeschoben wird. Gleichzeitig damit wird auch die Zunge 73 in dem Kanal 72 nach unten geschoben, wobei in der erreichten Endstellung die Öffnungen 74 mit den Bohrungen 51 fluchten und einen freien Durchtrifft der Steckerstifte 38 in die Bohrungen 51 ermöglichen.

Umgekehrt springt der Schieber 71 in die in Fig. 5 gezeigte Lage zurück, sobald der Teil 6 gezogen ist und der Kragen 43 von dem Betätigungsstück 75 freigekommen ist. Hierbei schiebt die Druckfeder 78 den Schieber 71 nach oben in eine Stellung, in der die Öffnungen 74 gegenüber den Bohrungen 51 versetzt sind. Diese sind daraufhin verschlossen.

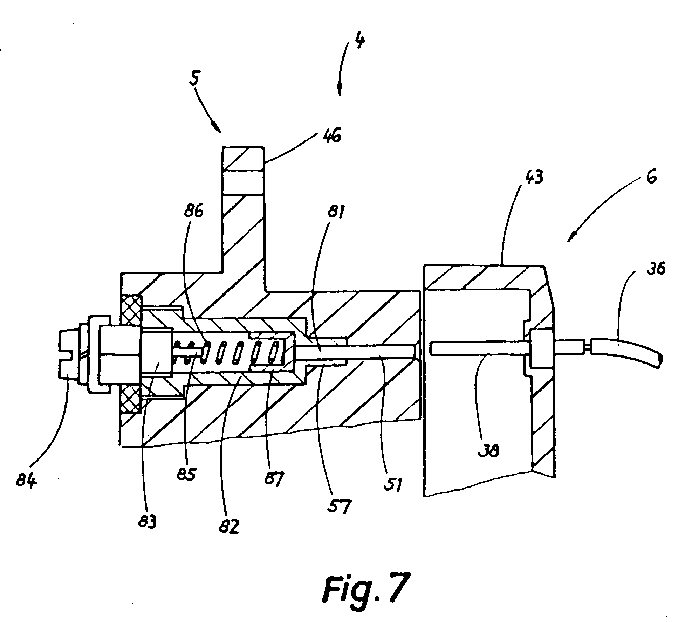

Bei dem in Fig. 7 gezeigten Ausführungsbeispiel erfolgt das Verschließen der Bohrung 51 durch einen Zapfen 81 aus einem Isolierstoff. An die Buchse 53 schließt sich hierbei nach rückwärts ein becherförmiger Fortsatz 82 an, in dessen Öffnung eine Verschlußschraube 83 eingeschraubt ist. Die Verschlußschraube 83 kann ihrerseits als Anschlußklemme ausgebildet sein und enthält beispielsweise hierfür ein nicht erkennbares Innengewinde, in das eine Klemmschraube 84 einschraubbar ist. Auf der in das becherförmige Teil 82 hineinragenden Stirnseite trägt die Verschlußschraube 83 einen Zentrierzapfen 85, auf dem eine als Schraubenfeder ausgebildete Druckfeder 86 aufgesteckt ist. Das andere Ende der Schraubenfeder 86 stützt sich in einem becherförmigen Fortsatz 87 des Zapfens 81 ab, so daß die Druckfeder 86 bestrebt ist, den Zapfen 81 durch die Buchse 53 in die Bohrung 51 vorzuschieben. Beim Einstecken des Teils 6 in den Teil 5 schiebt der Steckerstift 38 den Zapfen 51 vor sich her und durch die Buchse 53 hindurch in deren becherförmigen Fortsatz 82 und gibt damit die Bohrung 51 frei. Auch hier bildet der Zapfen 38 mit der Bohrung 51 einen zünddurchschlagsicheren Spalt, noch ehe die vorderste Spitze des Steckerstiftes 38 mit der Buchse 53 elektrischen Kontakt macht.

Umgekehrt ist bei gezogenem Teil 6 die Bohrung 51 durch den zylindrischen Zapfen 81 verschlossen, der beim Ziehen des Teils 6 von der Druckfeder 86 durch die Buchse 53 hindurch in die Bohrung 51 vorgeschoben wird.

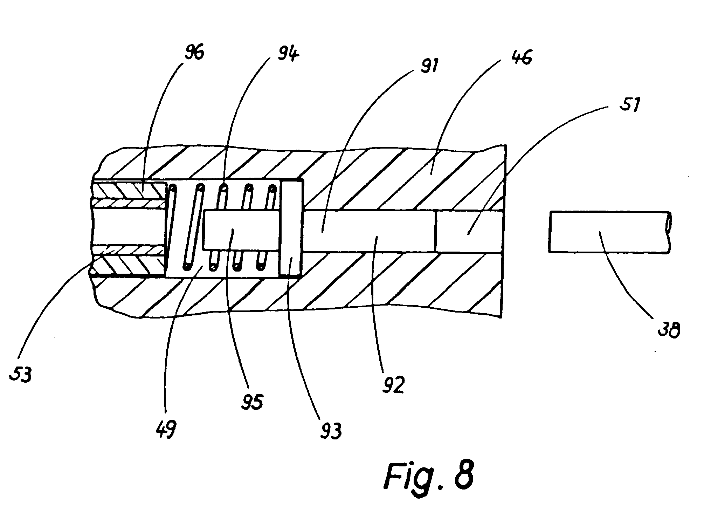

Bei dem Ausführungsbeispiel nach Fig. 8 ist die Buchse 53 zurückversetzt und zwischen der Bohrung 51 und der Buchse 53 ist ein aus einem elektrisch leitenden Material bestehender Bolzen 91 hin- und herschiebbar. Der Bolzen 91 weist einen Schaft 92 auf, der in der Bohrung 51 sich befindet und einstückig in einen Ringbund 93 größeren Durchmessers übergeht. Der Ringbund 93 legt sich an eine Ringschulter an, die an der Übergangsstelle von der zylindrischen Kammer 49, in der die Buchse 53 untergebracht ist, und der Bohrung 51 ausgebildet ist. Der Ringbund 93 trägt auf seiner der Buchse 53 gegenüberliegenden Stirnseite, an der sich eine als Schraubenfeder ausgebildete Druckfeder 94 abstützt, einen weiteren zylindrischen Zapfen 95, der dazu bestimmt ist, in die Buchse 53 einzudringen.

Wenn bei dieser Ausführungsform der Steckerstift 38 beim Einschieben des Modulgehäuses 3 in die Bohrung 51 eindringt, schiebt der Steckerstift 38, der mit der außenliegenden Stirnfläche des zylindrischen Schaftes 92 in Eingriff kommt, den Zapfen 91 gegen die Wirkung der Feder 94 vor sich her. Hierbei dringt der zylindrische Schaft 95 in die Buchse 53 ein, so daß eine elektrische Verbindung von der Buchse 53 über den Zapfen 91 zu der Stirnseite des Steckerstiftes 38 hergestellt wird.

Beim Herausziehen des Steckerstiftes 38 infolge eines Trennens der Teile 5 und 6 zieht die Druckfeder 98 den zylindrischen Zapfen 95 wieder aus der Buchse 53 heraus, so daß keine elektrische Verbindung mehr zu dem Zapfen 91 besteht.

Die Druckfeder 94 stützt sich im Inneren des Grundkörpers 46 auf einem Isolierstück 96 ab, das die Buchse 53 umgibt.

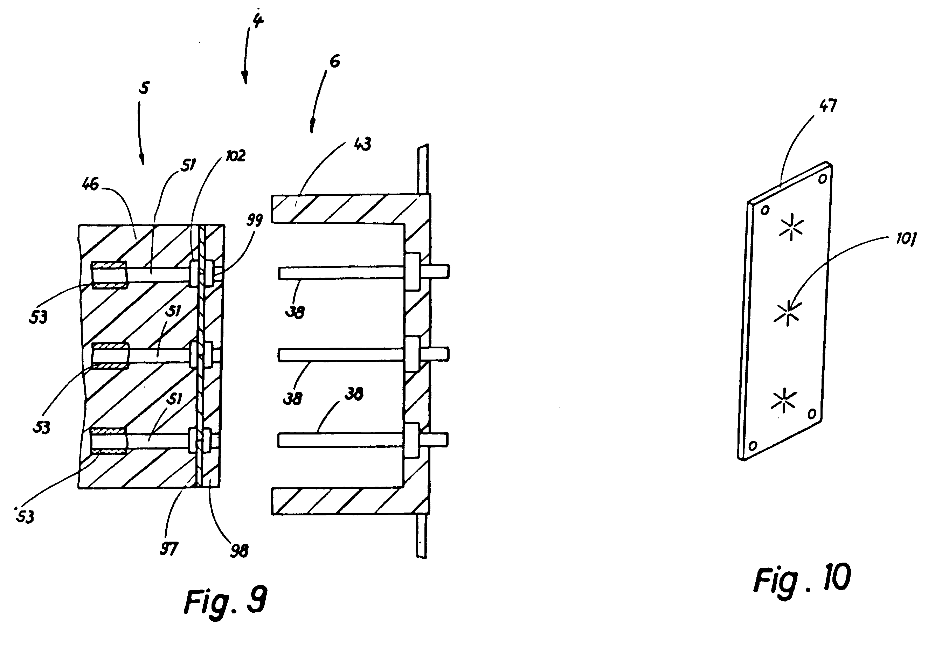

Schließlich ist es, wie die Fig. 9 und 10 zeigen, möglich, die Bohrungen 51 durch eine Membrane 97 aus einem gummielastischen Material zu verschließen, die auf der dem Teil 5 zugekehrten Seite des Grundkörpers 46 vor den Bohrungen 51 angebracht ist und dort mittels einer Befestigungsplatte 98 gehalten ist. Die Befestigungsplatte 98 enthält mit den Bohrungen 51 fluchtende Öffnungen 99, durch die hindurch die Steckerstifte 38 eindringen können. An denjenigen Stellen, an denen sich hinter der Membrane 97 die Bohrungen 51 befinden, ist die Membrane 97, wie Fig. 10 zeigt, mit sternförmig verlaufenden Einschnitten 101 versehen, so daß kleine Dreiecke entstehen, die an zwei Seiten von Schnitten begrenzt sind und die an der Grundseite mit dem Rest der Membrane 97 einstückig verbunden sind. Beim Einstecken des Teils 6 können die Steckerstifte die Membrane 97 dort, wo die sternförmigen Einschnitte 101 angebracht sind, durchdringen, um in die dahinter gelegenen Bohrungen 51 zu gelangen. Damit das dabei nach hinten ausweichende Material der Membrane 97 nicht an den Rändern der Bohrung 51 zerquetscht wird, sind die Bohrungen 51 unmittelbar hinter der Membrane 97 mit zylindrischen Ausnehmungen 102 ausgebildet, die Platz für die zurückweichenden Membranteile bilden.

Sobald der Teil gezogen ist, kehren die Membranteile elastisch in ihre Ausgangsstellung zurück, die in Fig. 10 veranschaulicht ist und verschließen die Bohrungen 51 gemäß der Schutzvorschrift IP 54.

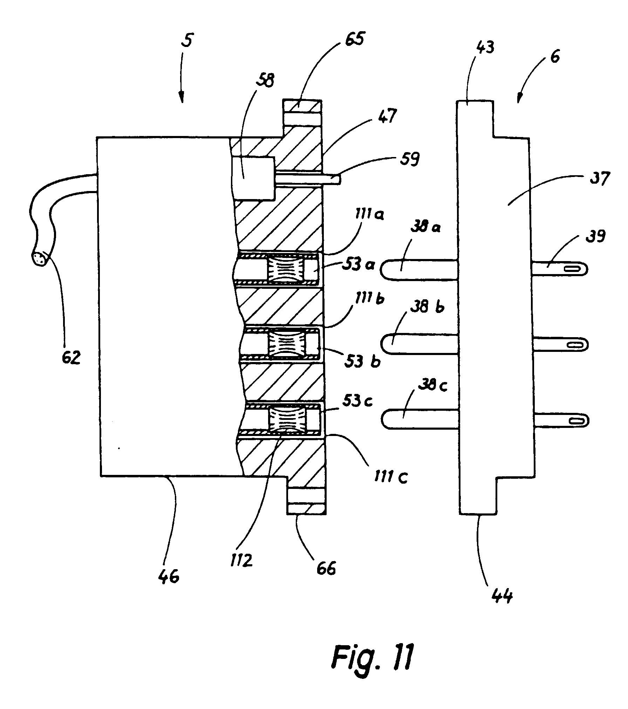

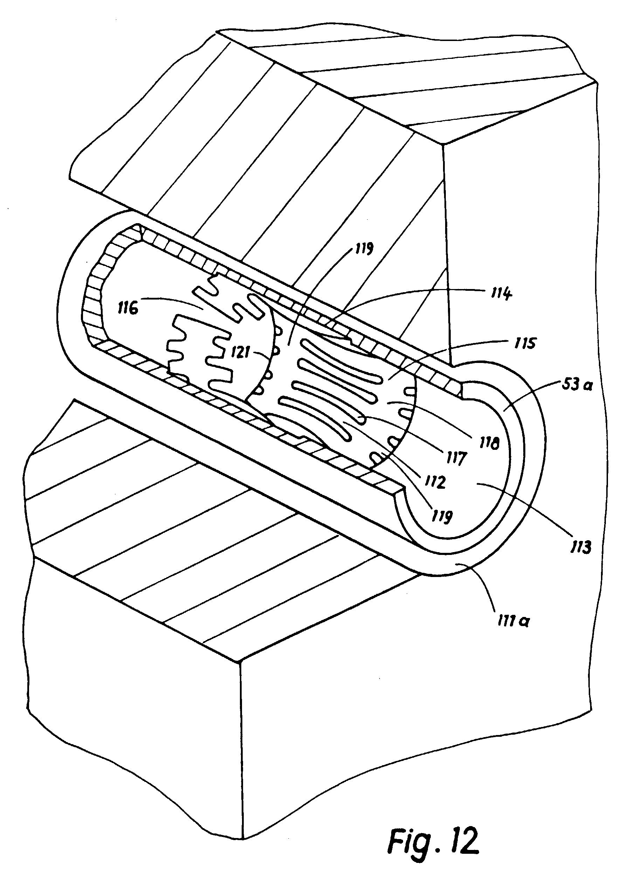

Anstelle einer Steckvorrichtung mit druckfester Kapselung der Kontaktmittel kann auch eine Steckvorrichtung 4 verwendet werden, bei der die Kontaktmittel 38, 53 in der Zündschutzart "Erhöhte Sicherheit" ausgeführt sind, um die elektrische Verbindung zwischen dem Modulgehäuse 3 und dem Baugruppenträger 2 herzustellen. Eine derartige Steckverbindungseinrichtung ist in den Fig. 11 und 12 schematisch veranschaulicht, wobei für bereits beschriebene Bauteile, soweit sie hier wiederkehren, dieselben Bezugszeichen verwendet sind.

Die Steckvorrichtung nach den Fig. 11 und 12 enthält wiederum einen in dem Modulträger 2 zwischen den Tragschienen 13 und 14 zu halternden Teil 5, bestehend aus einem Grundkörper 46 mit einer einstückig angeformten Grundplatte 47 und den Befestigungsfortsätzen 65 und 66. Die Grund¶ platte 47 enthält drei zylindrische Bohrungen 111a...111c, in denen schwimmend die Steckbuchsen 53a...53c angeordnet sind. Die Steckbuchsen 53a...53c springen nur geringfügig gegenüber der planen Vorderseite der Grundplatte 47 zurück und sind axial unverschieblich gehalten.

Um die Zündschutzart "Erhöhte Sicherheit" zu erfüllen, enthält jede der Steckbuchsen 53a...53c eine Vielzahl von Kontaktstellen 112, die innerhalb eines gewissen Bereiches weitgehend unabhängig voneinander federnd bewegbar sind und mit dem einzuführenden Steckerstift 38a...38c Kontakt machen.

Die Ausbildung der Vielzahl federnd elastischer Kontaktstellen ist aus Fig. 12 ersichtlich. Wie zu erkennen ist, enthält die dort vergrößert veranschaulichte Steckbuchse 53a, die im wesentlichen von einem zylindrischen Rohrstück mit einer lichten Weite von ca. 2 mm gebildet ist, knapp hinter ihrer vorderen Einführöffnung 113 eine umlaufende Nut 114, die in der Innenumfangsfläche der Buchse 53a eingestochen ist und die sich in deren Längsrichtung über ein beträchtliches Stück erstreckt, jedoch nur eine vergleichsweise geringe radiale Tiefe aufweist. In dieser Nut 114 ist ein mehrfach geschlitztes, etwa zylinderförmiges metallisches Kontaktstück 115 eingesetzt, dessen axiale Erstrekkung geringfügig größer ist als die axiale Erstrekkung der Nut 114, so daß sich das Kontaktstück 115 aufgrund der vor dem Einsetzen gegebenen Gestalt in Richtung auf die Längsachse der Buchse 53a konvex vorwölbt. Die lichte Weite des Kontaktstücks 115, das sich an seinen stirnseitig befindlichen Enden an den in Achsrichtung, bezogen auf die Buchse 53a gelegenen Flanken der Nut 114 abstützt, ist geringer als die lichte Weite der Buchse 53a in dem übrigen zylindrischen Bereich bzw. auch kleiner als der Außendurchmesser des einzuführenden Steckerstiftes 38a.

Um die mehrfachen und unabhängig voneinander bewegbaren Kontaktstellen zu erhalten, ist das rohrartig zusamengebogene Kontaktstück 115, das bei 116 mit einem durchgehenden Längsschlitz versehen ist, mit einer Vielzahl von randseitig geschlossenen Schlitzen 117 versehen, die zwischen sich in Richtung auf das Innere vorstehende Kontaktlamellen oder Kontaktstreifen begrenzen, die die Kontaktstellen 112 bilden. Infolge der nicht durchgehenden Schlitze 117 hängen diese Kontaktlamellen oder Kontaktstellen 112 einstückig an zwei in Umfangsrichtung verlaufenden Streifen 118, 119 einstückig zusammen, wobei diese beiden Streifen 118, 119 lediglich im Bereich des durchgehenden Schlitzes 116 unterbrochen sind.

Um auch mehrfach federnde Kontaktstellen mit der Buchse 53a herzustellen, sind die beiden in Umfangsrichtung verlaufenden Streifen 118, 119 von ihrer axial außen liegenden Kante her mehrfach eingeschlitzt oder eingekerbt, so daß sich voneinander unabhängig federnde und in axialer Richtung erstreckende Zungen 119, 121 ergeben, die sich an den Flanken der Nut 114 abstützen und über die der Kontakt des Kontaktstücks 115 mit dem Grundkörper der Steckbuchse 53a zustandekommt.

Beim Einstecken des Steckerstiftes 38a kommt die Außenumfangsfläche des Steckerstiftes 38 mit den Kontaktlamellen 112 in Berührung und drückt diese radial nach außen. Dabei bewegt sich jede der Kontaktlamellen 112 weitgehend unabhängig von den benachbarten Kontaktlamellen und kehrt auch beim Herauziehen des Steckerstiftes 38a wieder unabhängig von den übrigen Kontaktlamellen 112 federnd in die Ausgangsstellung zurück, wie sie in den Fig. 11 und 12 gezeigt ist.

Damit bei dieser Ausführungsform der Steckverbindungseinrichtung 4 die Stromunterbrechung nicht durch ein Trennen der Kontaktmittel 38, 53 zustandekommt, was zündfähige Funken hervorrufen könnte, ist, wie bei dem vorherigen Beispiel nach Fig. 4,zumindest in demjenigen Teil der Steckverbindungsrichtung 4, der zu Spannungsquellen hin verbunden ist, in Fig. 11 beispielsweise dem Teil 5, der mehrpolige elektrische Schalter 58 vorgesehen, dessen Betätigungsglied 59 durch die Frontplatte 47 in Richtung auf den einzusteckenden Teil 6 ragt. Der Schalter 58 ist wiederum druckfest gekapselt und seine Schaltstrecken liegen in Serie zu den Buchsen 53a...53c, so daß bei unbetätigtem Schalter 58 die Buchsen 53a...53c spannungslos geschaltet sind und keine Verbindung zu den Leitern des Kabels 62 haben.

Die Anordnung zwischen dem Betätigungshub des Schalters 58 und der Steck- bzw. Trennbewegung zwischen den beiden Teilen 5 und 6 ist so getroffen, daß beispielsweise beim Zusammenstekken der beiden Teile 5 und 6 zunächst die auf der Außenumfangsfläche glattzylindrischen Steckerstifte 38a...38c mit den Kontaktlamellen 112 elektrischen Kontakt und damit auch mit den Steckbuchsen 53a...53c elektrischen Kontakt herstellen, ehe das Betätigungsglied 59 mit dem Teil 6 in Eingriff kommt, um den druckfest gekapselten Schalter 58 in die Einschaltstellung zu überführen. Die Kontaktgabe zwischen den Kontaktmitteln 38 und 53 erfüllt bereits die Vorschrift "Erhöhte Sicherheit", wenn schließlich durch das weitere Zusammenstecken der beiden Teile 5 und 6 das Betätigungsglied 59 von dem weiter angenäherten Teil 6 betätigt wird und damit die Schaltstrecken des Schalters 58 schließen, um die Stromkreise über die Schaltmittel 38, 53 herzustellen.

Umkehrt werden sämtliche Stromkreise über die Kontaktstrecken, die von den Kontaktmitteln 38 und 53 gebildet sind, unterbrochen, noch ehe beim Auseinanderziehen der beiden Teile 5 und 6 die Steckerstifte 38a...38c von den Kontaktstellen 112 der Buchsen 53a...53c freigekommen sind, so daß in jedem Falle bei geschlossenen Kontaktstrecken des druckfest gekapselten Schalters 58 zwischen den Buchsen 53a...53c und den zugeordneten Steckerstiften 38a...38c elektrische Verbindungen bestehen, die die Vorschriften für die Zündschutzart "Erhöhte Sicherheit" erfüllen.

Anstatt die unabhängig voneinander bewegbaren Kontaktstellen 112 in der Buchse 53a...53c unterzubringen, können diese auch auf den Stekkerstiften 38a...38c angeordnet sein, wozu sich grundsätzlich ein Kontaktstück eignet, das, ähnlich wie das Kontaktstück 115 gestaltet ist, sich jedoch von dem Steckerstift konvex oder tonnenförmig nach außen wölbt. Schließlich besteht die Möglichkeit, den Steckerstift 38a...38c als sogenannten Büschelstecker auszuführen, bei dem der Steckerstift 38a...38c von einer Vielzahl einzeln beweglicher Federzungen gebildet ist. In beiden letztgenannten Fällen kann die Buchse 53a...53c als einfaches glattwandiges Rohrstück ausgeführt sein.

## Patentansprüche

1. Explosionsgeschütztes Modulgehäuse (3) für elektrische und/oder elektronische Baugruppen (29),
mit wenigstens einer die Baugruppe (29) enthaltenden Kammer (28), in der die Baugruppe (29) explosionsgeschützt ist,
mit einem an dem Modulgehäuse (3) vorgesehenen Teil (6) einer zweiteiligen explosionsgeschützten Steckverbindungseinrichtung (4), Über deren Kontaktmittel (38,53) zumindest die nicht eigensicheren elektrischen Verbindungen mit der Baugruppe (29) geführt sind, wobei der dem Modulgehäuse (3) zugeordnete Teil (6) zu einem anderen Teil (5) der Steckverbindungseinrichtung (4) komplementär ist, der nicht an dem Modulgehäuse (3) angebracht ist und
mit einer an dem Modulgehäuse (3) vorgesehenen handelsüblichen Stecker- oder Buchsenleiste für die eigensicheren Verbindungen zu der elektrischen und/oder elektronischen Baugruppe (29) in dem explosionsgeschützten Modulgehäuse (3).

2. Modulgehäuse nach Anspruch 1, dadurch gekennzeichnet, daß die Steckverbindungseinrichtung in der Zündschutzart "Druckfeste Kapselung" nach DIN EN 50018 "d" ausgeführt ist.

3. Modulgehäuse nach Anspruch 1, dadurch gekennzeichnet, daß die Steckverbindungseinrichtung in der Zündschutzart "Erhöhte Sicherheit" nach DIN EN 50019 "e" ausgeführt ist.

4. Modulgehäuse nach Anspruch 1, dadurch gekennzeichnet, daß es parallel und mit Abstand voneinander verlaufende Führungsglieder (31, 32) aufweist, und daß der dem Modulgehäuse (3) zugeordnete Teil (6) der Steckverbindungseinrichtung (4) im Bereich zwischen den Führungsgliedern (31, 32) bzw. deren imaginärer Verlängerung angeordnet ist.

5. Modulgehäuse nach Anspruch 1, dadurch gekennzeichnet, daß es eine Öffnung (33) enthält, in die der dem Modulgehäuse (3) zugeordnete Teil (6) der Steckverbindungseinrichtung (4) eingesetzt ist.

6. Modulgehäuse nach Anspruch 1, dadurch gekennzeichnet, daß beide Teile (5, 6) der Steckverbindungseinrichtung (4) jeweils einen Grundkörper (37, 46) aufweisen, in denen ihre Kontaktmittel (38, 53) gehaltert sind.

7. Modulgehäuse nach Anspruch 1, dadurch gekennzeichnet, daß der von dem Modulgehäuse (3) getrennte Teil (5) der Steckverbindungseinrichtung (4) für die Zuleitungen einen Anschlußraum in der Zündschutzart "Erhöhte Sicherheit" aufweist.

8. Modulgehäuse nach Anspruch 1, dadurch gekennzeichnet, daß die Zuleitungen in dem von dem Modulgehäuse (3) getrennten Teil (5) der Steckverbindungseinrichtung (4) vergossen sind.

9. Modulgehäuse nach Anspruch 1, dadurch gekennzeichnet, daß die Steckverbindungseinrichtung (4) auf zumindest einem Teil (6) wenigstens einen Steckerstift (38) enthält, der bei zusammengesteckten Teilen (5, 6) der zueinander komplementären Teile (5, 6) der Steckverbindungseinrichtung (4) von diesen beiden Teilen (5, 6) für sich und einzeln druckfest gekapselt ist.

10. Modulgehäuse nach Anspruch 1, dadurch gekennzeichnet, daß die Steckverbindungseinrichtung (4) zumindest eine Buchse (53) aufweist, die bei zusammengesteckten Teilen (5, 6) der zueinander komplementären Teile (5, 6) der Steckverbindungseinrichtung (4) von den Teilen (5, 6) der Steckverbindungseinrichtung (4) druckfest gekapselt ist.

11. Modulgehäuse nach Anspruch 1, dadurch gekennzeichnet, daß der Teil (5) der Steckverbindungseinrichtung (4) an derjenigen Stelle eine Bohrung (51) enthält, an der der andere Teil (6) der Steckverbindungseinrichtung (4) einen Steckerstift (38) trägt, und daß die Bohrung (51) im Zustand mit eingeführtem Steckerstift 38 zusammen mit dem Steckerstift (38) einen zünddurchschlagsicheren Spalt bildet, hinter dem die Kontaktstelle mit dem Steckerstift (38) liegt, und daß die Wand der Bohrung (51) im Bereich des zünddurchschlagsicheren Spaltes aus elektrisch nicht leitendem Material besteht.

12. Modulgehäuse nach Anspruch 11, dadurch gekennzeichnet, daß in Verlängerung der Bohrung (51) in dem die Bohrung (51) enthaltenden Teil (5) der Steckverbindungseinrichtung (4) eine Buchse (53) angeordnet ist.

13. Modulgehäuse nach Anspruch 11,dadurch gekennzeichnet, daß der Steckerstift (38) im Bereich des zünddurchschlagsicheren Spaltes einen vergrößerten Durchmesser (41), verglichen mit dem in Steckrichtung gesehen davorliegenden Abschnitt (42) aufweist.

14. Modulgehäuse nach Anspruch 1, dadurch gekennzeichnet, daß die Steckverbindungseinrichtung (4) in zumindest einem ihrer beiden zueinander komplementären Teile (4, 5) explosionsgeschützte Schaltermittel (58, 67) enthält, die dazu dient, beim Trennen der Teile (5, 6) der Steckverbindung (4) sonst strom- und/oder spannungsführende Buchsen (53) oder Stekkerstifte (38) strom- und/oder spannungslos zu schalten und die ein Betätigungsglied (59, 68) aufweisen, das bei zusammengesteckter Steckverbindungseinrichtung (4) von dem jeweils anderen Teil (5, 6) betätigbar ist.

15. Modulgehäuse nach Anspruch 14, dadurch gekennzeichnet, daß die Schaltermittel (58, 67) in der Zündschutzart "Druckfeste Kapselung" ausgeführt sind.

16. Modulgehäuse nach Anspruch 14, dadurch gekennzeichnet, daß die Schaltermittel (58, 67) elektrisch zwischen der jeweiligen Buchse (53) bzw. dem jeweiligen Steckerstift (38) und der zu der jeweiligen Buchse (53) bzw. dem jeweiligen Steckerstift (38) führenden elektrischen Verbindung (36, 62) liegen.

17. Modulgehäuse nach Anspruch 1, dadurch gekennzeichnet, daß der Bohrungen (51) enthaltende Teil (5) der Steckverbindungseinrichtung (4) Verschlußmittel (71, 81, 91, 97) für die Bohrungen (51) aufweist, die bei gezogenen Steckerstiften (38) die Bohrungen (51) verschließen.

18. Modulgehäuse nach Anspruch 17, dadurch gekennzeichnet, daß die Verschlußmittel einen oder mehrere Schieber (71) aufweisen, die quer zu der Längsachse der Bohrung (51) beweglich gehaltert sind und in der einen Stellung die Bohrung (51) verschließen und in der anderen die Bohrung (51) freigeben, und daß der bzw. die Schieber (71) von Abschnitten (43) an dem anderen Teil (6) der Steckverbindungseinrichtung (4) betätigbar sind.

19. Modulgehäuse nach Anspruch 18, dadurch gekennzeichnet, daß lediglich ein Schieber (71) vorhanden ist, der in dem Muster der Bohrungen (51) angeordnete Öffnungen (74) enthält, und rechtwinklig zu der Achse der Bohrungen (51) verschiebbar gelagert ist, und daß der Schieber (71) ein Betätigungsglied (76) aufweist, das mit einem Schutzkragen (43) des anderen Teils (6) der Steckverbindungseinrichtung (4) im Sinne eines Verschiebens des Schiebers (71) und Freigebens der Bohrungen (51) in Eingriff bringbar ist.

20. Modulgehäuse nach Anspruch 17, dadurch gekennzeichnet, daß die Verschlußmittel wenigstens einen aus elektrisch nicht leitendem Material bestehenden Zapfen (81) aufweisen, der in dem die Bohrung (51) enthaltenden Teil der Steckverbindungseinrichtung (4) längsverschieblich federvorgespannt angeordnet ist, derart, daß er bei gezogenem Steckerstift (38) die Bohrung (51) im wesentlichen ausfüllt und beim Einstecken des Steckerstiftes (38) in die Bohrung (51) entgegen der Vorschubbewegung des Steckerstiftes (38) in den entsprechenden Teil (5) der Steckverbindungseinrichtung (4) zurückweicht.

21. Modulgehäuse nach Anspruch 17, dadurch gekennzeichnet, daß zwischen der den zünddurchschlagsicheren Spalt begrenzenden Bohrung (51) und der in deren Verlängerung angeordneten Buchse (53) ein die Verschlußmittel bildender elektrisch leitender Stift (91) längsverschieblich angeordnet ist, der in der einen Stellung ohne elektrischen Kontakt mit der Steckbuchse (53) die Bohrung (51) im wesentlichen verschließt und, ausgehend von dieser Stellung, beim Einstecken des Steckerstiftes (38) bis zum Herstellen einer elektrischen Verbindung mit der Buchse (53) in Richtung auf die Buchse (53) vorschiebbar ist.

22. Modulgehäuse nach Anspruch 17, dadurch gekennzeichnet, daß die Verschlußmittel eine aus elastischem Material bestehende Membrane (97) enthalten, die vor der Bohrung (51) angeordnet und im Bereich der Bohrung (51) geschlitzt ist, derart, daß der Steckerstift (38) durch die Membrane (97) hindurch in die Bohrung (51) einführbar ist, und daß bei gezogenem Steckerstift (38) die elastisch in die Ausgangsstellung zurückkehrenden Membrane (97) die Bohrung (51) verschließen.

23. Modulgehäuse nach Anspruch 1, dadurch gekennzeichnet, daß der dem Modulgehäuse (3) zugeordnete Teil (6) der Steckverbindungseinrichtung (4) an einer Wand (26) des Modulgehäuses (3) angebracht ist.

24. Modulgehäuse nach Anspruch 1, dadurch gekennzeichnet, daß die Baugruppe (29) in der Kammer (28) in der Zündschutzart "Sandkapselung" nach DIN EN 50017 "q" geschützt ist.

25. Modulgehäuse nach Anspruch 1, dadurch gekennzeichnet, daß die Baugruppe (29) in der Kammer (28) in der Zündschutzart "Vergußkapselung" nach DIN EN 50028 "m" geschützt ist.

26. Modulgehäuse nach Anspruch 1, dadurch gekennzeichnet, daß die Baugruppe (29) in der Kammer (28) in der Zündschutzart "Druckfeste Kapselung" nach DIN EN 50018 "d" geschützt ist.

27. Modulgehäuse nach Anspruch 1, dadurch gekennzeichnet, daß die in der Zündschutzart "Erhöhte Sicherheit" nach DIN EN 50019 "e" ausgeführte Steckverbindungseinrichtung (4) zumindest in dem nach der Trennung ihrer Teile (5, 6) voneinander mit einer Spannungsquelle verbundenen Teil (5) für ihre entsprechenden Kontaktmittel (38, 53) in der Zündschutzart "Druckfeste Kapselung" nach DIN EN 50018 "d" ausgeführte Schaltermittel (58) aufweist, deren Betätigungsglied (59) durch den anderen Teil (6) betätigbar ist, derart, daß die Schaltermittel (58) die Stromzuleitung zu den Kontaktmitteln (38, 53) schließen bzw. öffnen, nachdem bzw. bevor die Kontaktmittel (38, 53) der beiden Teile (5, 6) in bzw. außer Eingriff kommen, und daß die jeweils eine Kontaktstrecke bildenden Kontaktmittel (38, 53) eine Vielzahl von voneinander weitgehend unabhängig federnd bewegbaren Kontaktstellen (112) aufweist.

28. Modulgehäuse nach Anspruch 27, dadurch gekennzeichnet, daß die voneinander unabhängig bewegbaren Kontaktstellen (112) in dem als Buchse ausgebildeten Kontaktmittel (53) angeordnet sind.

29. Modulgehäuse nach Anspruch 27, dadurch gekennzeichnet, daß die voneinander unabhängig bewegbaren Kontaktstellen (112) an dem als Steckerstift ausgebildeten Kontaktmittel (38) angeordnet sind.

30. Modulgehäuse nach Anspruch 27, dadurch gekennzeichnet, daß auch der andere Teil (6) für seine Kontaktmittel (38) Schaltermittel aufweist, die in der Zündschutzart "Druckfeste Kapselung" nach DIN EN 50018 "d" ausgeführt sind.

31. Baugruppenträger für eines oder mehrere der Modulgehäuse nach einem oder mehreren der vorhergehenden Ansprüche, mit einem Rahmen (8), in dem für jedes Modulgehäuse (3) paarweise Führungsglieder (16, 17) enthalten, sind, die innerhalb jedes Paares parallel und mit Abstand voneinander verlaufen, wobei der komplementäre Teil (5) der Steckverbindungseinrichtung (4) an derjenigen Stelle in dem Baugruppenträger (2) angeordnet ist, an der bei eingestecktem Modulgehäuse (3) der an dem Modulgehäuse (3) angebrachte Teil (6) der Steckverbindungseinrichtung (4) zu liegen kommt.

32. Baugruppenträger nach Anspruch 21, dadurch gekennzeichnet, daß der oder die in ihm gehalterten Teile der Steckverbindungseinrichtung(en) (4) ohne Steckerstifte (38) ausgebildet ist (sind).

## Claims

1. An explosion-proof module casing (3) for electric and/or electronic components (29),
having at least one chamber (28) which contains the component (29) and in which the component (29) is included explosion-proof,
having a part (6), provided on the module casing (3), of a two-part explosion-proof plug-in connecting device (4), by means of which contact means (38, 53) at least the non-intrinsically safe electric connections to the component (29) are provided, the part (6) associated with the module casing (3) being complementary with another part (5) of the plug-in connecting device (4) which is not disposed on the module casing (3), and
having a commercially available plug or bush strip provided on the module casing (3) for the intrinsically safe connections to the electric and/or electronic component (29) in the explosion-proof module casing (3).

2. A module casing according to claim 1, characterized in that the plug-in connecting device is constructed in type of protection flameproof enclosure "d" to DIN EN 50018.

3. A module casing according to claim 1, characterized in that the plug-in connecting device is constructed in type of protection increased safety "e" to DIN EN 50019.

4. A module casing according to claim 1, characterized in that it has guide members (31, 32) extending spaced-out in parallel, and the part (6) of the plug-in connecting device (4) associated with the module casing (3) is disposed in the zone between the guide members (31, 32) and their imaginary prolongation.

5. A module casing according to claim 1, characterized in that it comprises an opening (33) into which the part (6) of the plug-in connecting device (4) associated with the module casing (3) is inserted.

6. A module casing according to claim 1, characterized in that the two parts (5, 6) of the plug-in connecting device (4) each have a basic element (37, 46) in which their contact means (38, 53) are retained.

7. A module casing according to claim 1, characterized in that that part (5) of the plug-in connecting device (4) which is separated from the module casing (3) has a connecting space in type of "increased safety" for the leads.

8. A module casing according to claim 1, characterized in that the leads are potted in that part (5) of the plug-in connecting device (4) which is separated from the module casing (3).

9. A module casing according to claim 1, characterized in that the plug-in connecting device (4) comprises on at least one part (6) at least one plug pin (38) which, when the complementary parts (5, 6) of the plug-in connecting device (4) are joined together is individually flame-proof encapsluated by said two parts (5, 6).

10. A module casing according to claim 1, characterized in that the plug-in connecting device (4) has at least one bush (53) which, when the complementary parts (5, 6) of the plug-in connecting device (4) are joined together, is flameproof encapsulated by said parts (5, 6) of the plug-in connecting device (4).

11. A module casing according to claim 1, characterized in that one part (5) of the plug-in connecting device (4) comprises a bore (51) at that place at which the other part (6) of the plug-in connecting device (4) bears a plug pin (38), and in the state with the plug pin (38) introduced, the bore (51) forms together with the plug pin (38) flameproof gap behind which the contact place with the plug pin (38) is situated, the wall of the bore (51) being made of an electrically nonconductive material in the zone of the flameproof gap.

12. A module casing according to claim 11, characterized in that a bush (53) is disposed in that part (5) of the plug-in connecting device (4) which contains the bore (51) in the prolongation thereof.

13. A module casing according to claim 11, characterized in that in the zone of the flameproof gap the plug pin (38) has an enlarged diameter (41) in comparison with the preceding part (42), as viewed in the plugging-in direction.

14. A module casing according to claim 1, characterized in that the plug-in connecting device (4) comprises in at least one of its two complementary parts (4, 5) explosion-proof switch means (58, 67) which are provided to cut off the voltage and/or the current at the otherwise current-carrying and/or voltage-carrying bushes (53) or plug pins (38) when the parts (5,6) of the plug-in connecting device (4) are separated and which include actuating member (59, 68) which can be actuated by the particular other part (5, 6) when the plug-in connecting device (4) is joined together.

15. A module casing according to claim 14, characterized in that the switch means (58, 67) are of the type of protection "flameproof enclosure".

16. A module casing according to claim 14, characterized in that the switch means (58, 67) are disposed electrically between the particular bush (53) or the particular plug pin (38) and the electric connection (36, 62) extending to the particular bush (53) or the particular plug pin (38).

17. A module casing according to claim 1, characterzied in that that part (5) of the plug-in connecting device (4) which comprises the bores (51) has closure means (71, 81, 91, 97) for the bores (51) which close the bores (51) when the plug pins (38) are pulled.

18. A module casing according to claim 17, characterized in that the closure means include one or more slider means (71) which are retained shiftable transversely of the longitudinal axis of the bore (51) and which in one position close the bore (51) and in the other release the bore (51), and the or each slider means (79) can be actuated by portions (43) on the other part (6) of the plug-in connecting device (4).

19. A module casing according to claim 18, characterized in that only one slider means (71) is provided which comprises openings (74) disposed in the pattern of the bores (51) and which is mounted for displacement at right angles to the axis of the bores (51), the slider means (71) having an actuating member (76) which can be brought into engagement with a protective collar (43) of the other part (6) of the plug-in connecting device (4) for the displacement of the slicer means (71) and the release of the bores (51).

20. A module casing according to claim, 17, characterized in that the closure means have at least one pin (81) which is made of an electrically non-conductive material and which is so disposed spring-biased for longitudinal displacement in the part of the plug-in connecting device (4) provided with the bore (51) that when the plug pin (38) is pulled, the pin (81) substantially fills the bore (51) and when the plug pin (38) is inserted the pin (81) yields back into the bore (51) against the forward movement of the plug pin (38) into the corresponding part (5) of the plug-in connecting device (4).

21. A module casing according to claim 17, characterized in that disposed longitudinally displaceably between the bore (51) bounding the flameproof gap joint and the bush (53) disposed in its prolongation is an electrically conductive pin (91) which forms the closure means and which in one position substantially closes the bore (51) without electric contact with the bush (53) and, starting from that position, can be advanced on the insertion of the plug pin (38) in the direction of the bush (53) until an electric connection is made therewith.

22. A module casing according to claim 17, characterized in that the closure means comprise a membrane (97) which is made of a resilient material and which is disposed in front of the bore (51) and is so slotted in the zone thereof that the plug pin (38) can be introduced through the membrane (97) into the bore (51), and when the plug pin (38) is pulled, the membrane (97) returns resiliently to the starting position to close the bore (51).

23. A module casing according to claim 1, characterized in that the part (6) of the plug-in connecting device (4) associated with the modul casing (3) is disposed on a wall (26) thereof.

24. A module casing according to claim 1, characterized in that the component (29) in the chamber (28) is protected in type of protection powder filling "q" to DIN EN 50017.

25. A module casing according to claim 1, characterized in that the component (29) in the chamber (28) is protected in type of protection moulding "m" to DIN EN 50028.

26. A module casing according to claim 1, characterized in that the component (29) in the chamber (28) is protected in type of protection flameproof enclosure "d" to DIN EN 50018.

27. A modul casing according to claim 1, characterized in that at least in the part (5) connected to a voltage source after the separation of its parts (5, 6) from one another the plug-in connecting device (4) constructed in type of construction increased safety "e" to DIN EN 50019 has for its corresponding contact means (38, 53) switch means (58) which are constructed in type of protection flameproof enclosure "d" to DIN EN 50018, whose actuating member (59) can be so actuated by the other part (6) that the switch means (58) close or open the current supply to the contact means (38, 53) respectively after and before the contact means (38, 53) of the two parts (5, 6) are engaged or disengaged respectively, the contact means (38, 53) forming a contact path each having a plurality of contact places (112) movable resiliently substantially independently of one another.

28. A module casing according to claim 27, characterized in that the contact places (112) movable independently of one another are disposed in contact means (53) taking the form of a bush.

29. A module casing according to claim 27, characterized in that the contact places (112) movable independently of one another are disposed on the contact means (38) taking the form of a plug pin.

30. A module casing according to claim 27, characterized in that the other part (6) also has for its contact means (38) switch means which are constructed in type of protection flameproof enclosure "d" to DIN EN 50018.

31. A component support for one or more of the module casings according to one or more of the preceding claims, having a frame (8) containing for each module casing (3) gide members (16, 17) in pairs which extend spaced-out in parallel within each pair, the complementary part (5) of the plug-in connecting device (4) being disposed at that place in the component support (2) at which the part (6) of the plug-in connecting device (4) disposed on the module casing (3) comes to lie when the module casing (3) is inserted.

32. A component support according to claim 21, characterized in that the or each part of the or each plug-in connecting device (4) retained therein is constructed without plug pins (38).

## Revendications

1. Boîtier modulaire (3) antidéflagrant pour ensembles (29) électriques et/ou électroniques, comprenant
au moins une chambre (28) contenant l'ensemble (29) et dans laquelle l'ensemble (29) est protégé contre les explosions,
une partie (6) prévue sur le boîtier modulaire, d'un dispositif de connexion multibroches (4) antidéflagrant en deux parties dont les moyens de contact (38, 53) assurent au moins les liaisons électriques sans sécurité intrinsèque avec l'élément (29), la partie (6) associée au boîtier modulaire (3) étant complémentaire à une autre partie (5) du dispositif de connexion multibroches (4) qui n'est pas disposée sur le boîtier modulaire (3) et
une barrette à broches ou à douilles courante pour les connexions à sécurité intrinsèque avec le composant (29) électrique et/ou électronique à l'intérieur du boîtier modulaire antidéflagrant.

2. Boîtier modulaire selon la revendication 1, en ce que le dispositif de connexion multibroches possède une protection de la classe "enveloppe antidéflagrante" selon la norme DIN EN 50018 "d".

3. Boîtier modulaire selon la revendication 1, caractérisé en ce que le dispositif de connexion multibroches possède une protection de "sécurité augmentée e"' selon la norme DIN EN 50019 "e".

4. Boîtier modulaire selon la revendication 1, caractérisé en ce qu'il présente des organes de guidage (31, 32) qui s'étendent parallèlement entre eux et sont écartés l'un de l'autre et que la partie (6) du dispositif de connexion multibroches (4) associée au boîtier modulaire (3) est disposée dans la zone comprise entre les organes de guidage (31, 32~ ou leur prolongement imaginaire.

5. Boîtier modulaire selon la revendication 1, caractérisé en ce qu'il contient une ouverture (33) dans laquelle est montée la partie (6) du dispositif de connexion multibroches (4) associée au boîtier modulaire (3).

6. Boîtier modulaire selon la revendication 1, caractérisé en ce que les deux parties (5, 6) du dispositif de connexion multibroches (4) présentent chacune un corps (37, 46) dans lequel sont montés leurs moyens de contact (38, 53).

7. Boîtier modulaire selon la revendication 1, caractérisé en ce que la partie (5) du dispositif de connexion multibroches (4) séparée du boîtier modulaire (3) présente pour les conducteurs d'amenée une zone de raccordement agencée conformément à la protection "sécurité augmentée".

8. Boîtier modulaire selon la revendication 1, caractérisé en ce que les conducteurs d'amenée sont scellés dans la partie (5) du dispositif de connexion multibroches (4) séparée du boîtier modulaire (3).

9. Boîtier modulaire selon la revendication 1, caractérisé en ce que le dispositif de connexion multibroches (4) contient sur au moins une partie (6) au moins une pointe de contact (38) qui, lorsque les parties (5, 6) complémentaires du dispositif de connexion multibroches (4) sont assemblées, est individuellement blindée à l'épreuve de la pression par ces deux parties (5, 6).

10. Boîtier modulaire selon la revendication 1, caractérisé en ce que le dispositif de connexion multibroches (4) présente au moins une douille (53) qui, lorsque les parties (5, 6) complémentaires du dispositif de connexion multibroches (4) sont assemblées, est blindée à l'épreuve de la pression par les parties (5, 6) du dispositif de connexion multibroches (4).

11. Boîtier modulaire selon la revendication 1, caractérisé en ce que la partie (5) du dispositif de connexion multibroches (4) contient un perçage (51) à l'endroit où l'autre partie (6) du dispositif de connexion multibroches (4) porte une pointe de contact (38) et en ce que lorsque la pointe de contact (38) est introduite, le perçage (51) forme avec la pointe de contact (38) un joint antidéflagrant derrière lequel se trouve le point de contact avec la pointe de contact (38) et en ce que la paroi du perçage (51) est constituée d'un matériau non électroconducteur dans la région du joint antidéflagrant.

12. Boîtier modulaire selon la revendication 11, caractérisé en ce qu'une douille (53) est disposée dans le prolongement du perçage (51), dans la partie (5) du dispositif de connexion multibroches (4) contenant le perçage (51).

13. Boîtier modulaire selon la revendication 11, caractérisé en ce que la pointe de contact (38) présente, dans la région du joint antidéflagrant, un diamètre (41) agrandi par rapport à la partie (42) qui se trouve avant vu dans la direction d'enfichage.

14. Boîtier modulaire selon la revendication 1, caractérisé en ce que le dispositif de connexion multibroches (4) contient dans au moins une de ses deux parties (5, 6) mutuellement complémentaires, des moyens de commutation (58, 67) antidéflagrants qui servent, lors de la séparation des parties (5, 6) du dispositif de connexion multibroches (4), à interrompre le passage de courant dans et/ou à mettre hors tension des douilles (53) ou des pointes de contact (38) autrement conductrices et/ou sous tension et présentent un organe de commande (59, 68) qui, lorsque le dispositif de connexion multibroches (4) est assemblé, est actionné par l'autre partie (5, 6).

15. Boîtier modulaire selon la revendication 14, caractérisé en ce que les moyens de commutation (58, 67) sont conformes à la classe de protection "enveloppe antidéflagrante".

16. Boîtier modulaire selon la revendication 14, caractérisé en ce que les moyens de commutation (58, 67) sont situés du point de vue électrique entre la douille (53) concernée ou la pointe de contact (38) concernée et le conducteur électrique (36, 62) menant à la douille (53) concernée ou à la pointe de contact (38) concernée.

17. Boîtier modulaire selon la revendication 1, caractérisé en ce que la partie (5) du dispositif de connexion multibroches (4) contenant des perçages (51) présente des moyens d'obturation (71, 81, 91, 97) des perçages (SI) qui obturent les perçages (51) lorsque les pointes de contact (38) sont retirées.

18. Boîtier modulaire selon la revendication 17, caractérisé en ce que les moyens d'obturation présentent un ou plusieurs coulisseau(x) (71~ qui sont montés mobiles transversalement à l'axe longitudinal du perçage (51), obturent dans une position le perçage (51) et le libèrent dans l'autre position et en ce que le ou les coulisseau(x) (71) peuvent être actionnés par des parties (43) situées sur l'autre partie (6) du dispositif de connexion multibroches (4).

19. Boîtier modulaire selon la revendication 18, caractérisé en ce qu'il existe un seul coulisseau (71) qui contient des ouvertures (74) disposées sur le modèle des perçages (51) et est monté mobile en translation perpendiculairement à l'axe des perçages (51) et en ce que le coulisseau (71) présente un organe de commande (76) qui peut s'engager dans une collerette de protection (43) de l'autre partie (6) du dispositif de connexion multibroches (4) en déplaçant le coulisseau (71) en en libérant les-perçages (51).

20. Boîtier modulaire selon la revendication 17, caractérisé en ce que les moyens d'obturation présentent au moins un embout (81) en matériau non électroconducteur qui est disposé dans la partie du dispositif de connexion multibroches (4) contenant le perçage (51) en étant sollicité par un ressort et de façon à pouvoir être déplacé~ longitudinalement de telle manière que lorsque la pointe de contact (38) est retirée, il remplisse pour l'essentiel le perçage (51) et rentre dans la partie (5) correspondante du dispositif de connexion multibroches (4) dans le sens inverse de la direction d'avance de la pointe de contact (38), lorsque la pointe de contact (38) est introduite dans le perçage (51).

21. Boîtier modulaire selon la revendication 17, caractérisé en ce qu'une broche (91) électroconductrice formant les moyens d'obturation est disposée entre le perçage (51) limitant le joint antidéflagrant et la douille (53) disposée dans le prolongement dudit perçage de manière à pouvoir être déplacée longitudinalement, laquelle broche obture pour l'essentiel le perçage (51) dans une position où elle n'est pas en contact électrique avec la douille (53) et peut, à partir de cette position, être avancée en direction de la douille (53) lors de l'enfichage de la pointe de contact (38) jusqu'à l'établissement d'une liaison électrique avec la douille (53).

22. Boîtier modulaire selon la revendication 17, caractérisé en ce que les moyens d'obturation contiennent une membrane (97) en matériau élastique qui est disposée devant le perçage (51) et est fendue dans la région du perçage (51) de telle manière que la pointe de contact (38) puisse être introduite dans le perçage (51) en traversant la membrane (97) et en ce que lorsque la pointe de contact (38) est retirée, la membrane (97) revenant élastiquement dans la position de départ obture le perçage (51).

23. Boîtier modulaire selon la revendication 1, caractérisé en ce que la partie (6) du dispositif de connexion multibroches (4) associée au boîtier modulaire (3) est montée sur une paroi (26) du boîtier modulaire (3).

24. Boîtier modulaire selon la revendication 1, caractérisé en ce que l'élément (29) situé dans la chambre (28) est protégé conformément à la classe de protection "remplissage pulvérulent" "q" selon la norme DIN EN 50017.

25. Boîtier modulaire selon la revendication 1, caractérisé en ce que l'élément (29) situé dans la chambre (28) est protégé conformément à la classe de protection "enveloppe moulée" "m" selon la norme DIN 50028.

26. Boîtier modulaire selon la revendication 1, caractérisé en ce que l'élément (29) dans la chambre (28) est protégé conformément à la classe de protection "enveloppe antldéflagrante" "d" selon la norme DIN EN 50018.

27. Boîtier modulaire selon la revendication 1, caractérisé en ce que le dispositif de connexion multibroches (4) protégé conformément à la classe de protection "sécurité augmentée" "e" selon la norme DIN EN 50019 "e" présente, au moins dans la partie (5) reliée à une source de tension après la séparation de ses parties (5, 6), pour ses moyens de contact (38, 53) correspondants, des moyens de commutation (58) qui sont réalisés conformément à la classe de protection "enveloppe antidéflagrante" "d" selon la norme DIN EN 50018 et dont l'organe de commande (59) peut être actionné par l'autre partie (6) de telle manière que les moyens de commutation (58) ferment ou ouvrent l'alimentation en courant des moyens de contact (38, 53) après ou avant que les moyens de contact (38, 53) soient engagés l'un dans l'autre ou soient désengagés et en ce que les moyens de contact (38, 53) formant chacun une distance de contact présentent une pluralité de points de contact (112) pouvant être déplacés élastiquement largement indépendamment les uns des autres.

28. Boîtier modulaire selon la revendication 27, caractérisé en ce que les points de contact (112) pouvant être déplacés élastiquement indépendamment les uns des autres sont disposés dans le moyen de contact (53) réalisé sous forme de douille.

29. Boîtier modulaire selon la revendication 27, caractérisé en ce que les points de contact (112) pouvant être déplacés indépendamment les uns des autres sont disposés sur le moyen de contact (38) réalisé sous forme de pointe de contact (38).

30. Boîtier modulaire selon la revendication 27, caractérisé en ce que l'autre partie (6) présente aussi pour ses moyens de contact (38) des moyens de commutation qui sont réalisés conformément à la classe de protection "enveloppe antidéflagrante "d"" selon la norme DIN EN 50018.

31. Support pour un ou plusieurs boîtiers modulaires selon l'une ou plusieurs des revendications précédentes, comprenant un cadre (8) qui comporte pour chaque boîtier modulaire (3) une paire d'organes de guidage (16, 17) qui s'étendent parallèlement et à distance l'un de l'autre, la partie (5) complémentaire du dispositif de connexion multibroches (4) étant disposée dans le support (2) à l'endroit où vient prendre appui la partie (6) du dispositif de connexion multibroches (4) disposée sur le boîtier modulaire (3) lorsque le boîtier modulaire (3) est enfiché.

32. Support selon la revendication 21, caractérisé en ce que la ou les partie(s) du ou des dispositif(s) de connexion multibroches (4) qu'il contient est (sont) réalisée(s) sans pointes de contact (38).
